# EUROPEAN PATENT APPLICATION

(11) **EP 2 003 230 A2**
(43) Date of publication of application: **17.12.2008**
(21) Application number: 08010283.3
(22) Date of filing: 05.06.2008
(51) Int. Cl.: C30B 25/02, C30B 25/18, C30B 25/04, C30B 29/40, C23C 16/01, H01L 21/205

(54) **GaN substrate, substrate with an epitaxial layer, semiconductor device, and GaN substrate manufacturing method**

(30) Priority: 14.06.2007 JP 2007157783; 30.11.2007 JP 2007310700
(71) Applicant: Sumitomo Electric Industries, Ltd., Osaka-shi, Osaka 541-0041 (JP)
(72) Inventor: Kasai, Hitoshi, Itami-shi Hyogo 664-0016 (JP); Ishibashi, Keijii, Itami-shi Hyogo 664-0016 (JP); Nakahata, Seiji, Itami-shi Hyogo 664-0016 (JP); Akita, Katsushi, Itami-shi Hyogo 664-0016 (JP); Kyono, Takashi, Itami-shi Hyogo 664-0016 (JP); Miura, Yoshiki, Itami-shi Hyogo 664-0016 (JP)
(74) Representative: Grünecker, Kinkeldey, Stockmair & Schwanhäusser Anwaltssozietät

(57) **Abstract**

Affords a GaN substrate from which enhanced-emission-efficiency light-emitting and like semiconductor devices can be produced, an epi-substrate in which an epitaxial layer has been formed on the GaN substrate principal surface, a semiconductor device, and a method of manufacturing the GaN substrate. The GaN substrate is a substrate having a principal surface with respect to whose normal vector the [0001] plane orientation is inclined in two different off axis directions.

## Description

### BACKGROUND OF THE INVENTION

### Technical Field

The present invention relates to GaN substrates, to substrates with an epitaxial layer, to semiconductor devices, and to methods of manufacturing GaN substrates, and more specifically relates to GaN substrates, such substrates having an epitaxial layer, and semiconductor devices, having utilizable semipolar surfaces, and to methods of manufacturing such GaN substrates.

### Description of the Related Art

Conventionally, GaN laser diodes (LD) and light-emitting diodes (LED) are well known. GaN LDs and LEDs have been formed by depositing epitaxial layers onto the (0001) surface of a sapphire, SiC or GaN substrate. A problem with thus-formed LDs and LEDs has been that because the (0001) plane of the GaN or other substrate is the polar plane, the LED emission efficiency drops for emission-wavelength ranges of wavelengths longer than 500 nm.

"Press Release: Success in Developing LEDs on Semipolar Bulk GaN Substrates," [online], June 30, 2006, Kyoto University, [searched June 1, 2007], Internet, http://wwwkyoto-u.ac.jp/notice/05 news/documents/060630 1.htm, reports that to address this problem, forming quantum well structures not on the conventional (0001) plane in GaN crystal, but on the (11-22) plane, which is a semipolar crystallographic plane, enhances the emission efficiency for the just-noted longer wavelength ranges. Furthermore, Japanese Unexamined Pat. App. Pub. No. 2005-298319 proposes a method of manufacturing a GaN substrate in which a semipolar crystallographic plane is exposed on the principal surface.

The LEDs that the Kyoto University press release discloses exploit semipolar crystallographic planes that form naturally as microfacets, with the crystallographic plane being fixed as the (11-22) plane, and thus are small-scale. Taking the efficient manufacture of LEDs and LDs into consideration, however, utilizing 2-inch or greater, large diametric span GaN substrates having a semipolar crystallographic plane exposed on the principal surface (that is, having a so-called off-axis angle, in which a predetermined plane orientation-the [0001] direction for example-is inclined at a predetermined angle in a predetermined direction with respect a normal to the principal surface) to manufacture such light-emitting devices would be advantageous. Furthermore, the possibility that adjusting the angle at which the plane orientation is inclined with respect to the principal-surface normal vector (that is, varying the crystallographic plane that is exposed on the substrate principal surface) could improve LED and LD properties is conceivable.

### BRIEF SUMMARY OF THE INVENTION

An object of the present invention, brought about to resolve the problems discussed above, is to make available: GaN substrates having a large diameter of 2 inches or more, from which semiconductor devices such as light-emitting devices whose emission efficiencies have been enhanced can be produced at industrially low cost; such substrates with an epitaxial layer, in which an epitaxial layer has been formed on the principal surfaces of the GaN substrates; semiconductor devices; and methods of manufacturing the GaN substrates.

With the above-described GaN substrate manufacturing method disclosed in Japanese Unexamined Pat. App. Pub. No. 2005-298319, the inventors of the present invention prepared GaN substrates having different off-axis angles, and formed an epitaxial layer on the GaN substrate principal surfaces to experimentally produce LEDs. As a result of examining their properties, the inventors found that with respect to a normal to the principal surface of a GaN substrate, inclining the [0001] plane orientation in one plane orientation (one off-axis direction) makes the crystal plane exposed on the GaN substrate surface semipolar, and further inclining the [0001] plane orientation in a different plane orientation (in a different off-axis direction) enables controlling (decreasing) fluctuations in the wavelength distribution along the GaN substrate principal surface. More precisely, a GaN substrate in one aspect of the present invention is a GaN substrate having a principal surface with respect to whose normal vector the [0001] plane orientation is inclined in two different off-axis directions.

Such a GaN substrate permits, with the substrate principal surface being made semipolar by inclining the [0001] plane orientation in a first off-axis direction, epitaxial layer formation on the principal surface. Therefore, forming an epitaxial layer on the principal surface that has been made semipolar heightens the emission efficiency of a light-emitting device whose emission wavelengths are included in a longer-wavelength range of 500 nm or more, and makes the amount of wavelength shift caused by variation of the amount of applied electric current smaller, than forming an epitaxial layer on a GaN substrate polar surface such as the (0001) plane to manufacture LEDs and other light-emitting devices. Additionally, further inclining the [0001] plane orientation in a second off-angle direction enables controlling in-plane wavelength fluctuations in the GaN substrate principal surface. As a result, by employing such GaN substrates, superiorly performing LEDs and like semiconductor devices can be manufactured stably.

The substrate with an epitaxial layer in another aspect of the present invention is provided with the GaN substrate and an epitaxially grown layer formed on the GaN substrate principal surface. Forming the epitaxially grown layer on the GaN substrate principal surface means that the epitaxially grown layer is formed on the semipolar surface of the GaN substrate, making it possible to afford the substrate with an epitaxial layer from which semiconductor devices such as light-emitting devices whose emission wavelengths are included in a range of long wavelength of 500 nm or more, and whose emission efficiencies have been enhanced can be stably manufactured.

In the semiconductor device in a further aspect of the present invention, the substrate with an epitaxial layer is employed. Employing this substrate with an epitaxial layer enables obtaining semiconductor devices such as light-emitting devices whose emission wavelengths are included in a longer-wavelength range of 500 nm or more, and whose emission efficiencies are enhanced, with a little amount of wavelength shift in accordance with the amount of applied electric current.

The GaN substrate manufacturing method in yet another aspect of the present invention is provided with the following steps. That is, first, a step of preparing an undersubstrate with respect to whose principal surface normal vector, a reference or fiducial plane is inclined in two different inclination directions toward undersubstrate is carried out. A step of growing a GaN crystal layer on the undersubstrate principal surface is performed. A step of removing the undersubstrate from the GaN crystal layer to produce a GaN substrate composed of the GaN crystal layer is carried out. The GaN substrate has a principal surface, with [0001] plane orientation inclining in two different off-axis angles with respect to the substrate principal surface normal vector. Changing the angles at which the undersubstrate fiducial plane orientation is inclined in the inclination directions toward undersubstrate adjusts the angles at which the GaN substrate [0001] plane orientation is inclined in the off-axis angles. As a result, the GaN substrate of the present invention can be readily produced. Also, such a change of the angles at which the undersubstrate fiducial orientation is inclined in the inclination directions toward undersubstrate facilitates manufacturing of the GaN substrate in which the inclination angles in the off-axis directions are varied to any angles.

The present invention affords a GaN substrate from which semiconductor devices, such as light-emitting devices whose emission efficiencies have been enhanced in a range of wavelength longer than 500 nm, can be stably produced, a substrate with an epitaxial layer, a semiconductor device, and a method of manufacturing the GaN substrate.

From the following detailed description in conjunction with the accompanying drawings, the foregoing and other objects, features, aspects and advantages of the present invention will become readily apparent to those skilled in the art.

### BRIEF DESCRIPTION OF THE SEVERAL VIEWS OF THE DRAWINGS

Fig. 1 is a schematic perspective view showing the GaN substrate of the present invention.

Fig. 2 is a schematic diagram for explaining the crystal structure of the GaN substrate in Fig. 1.

Fig. 3 is a schematic diagram for explaining the plane orientations and crystal planes in the GaN substrate crystal structure illustrated in Fig. 2.

Fig. 4 is a schematic diagram for explaining the inclination angles in the GaN substrate of the present invention in Fig. 1 in off-axis directions.

Fig. 5 is a flow chart for representing the method of manufacturing the GaN substrate illustrated in Fig. 1.

Fig. 6 is a flow chart for explaining in detail the preparation step represented in Fig. 5.

Fig. 7 is a schematic plane diagram illustrating a mask pattern of the mask layer formed on the undersubstrate principal surface.

Fig. 8 is a schematic plane diagram illustrating another mask pattern of the mask layer formed on the undersubstrate principal surface.

Fig. 9 is a schematic diagram illustrating the film deposition device employed in the film deposition step (*S*20).

Fig. 10 is a schematic perspective view illustrating the substrate with an epitaxial layer, in which the GaN substrate of the present invention illustrated in Fig. 1 is employed.

Fig. 11 is a schematic cross-sectional view illustrating the light-emitting device incorporating the GaN substrate of the present invention.

Fig. 12 is a graph plotting relationships between electric current applied to light-emitting devices and the wavelength of light emitted from the devices.

### DETAILED DESCRIPTION OF THE INVENTION

Hereinafter, referring to the figures, embodiments of the present invention will be described. It should be understood that in the drawings accompanying the present description, identical or equivalent features are labeled with identical reference marks, and their explanation will not be repeated.

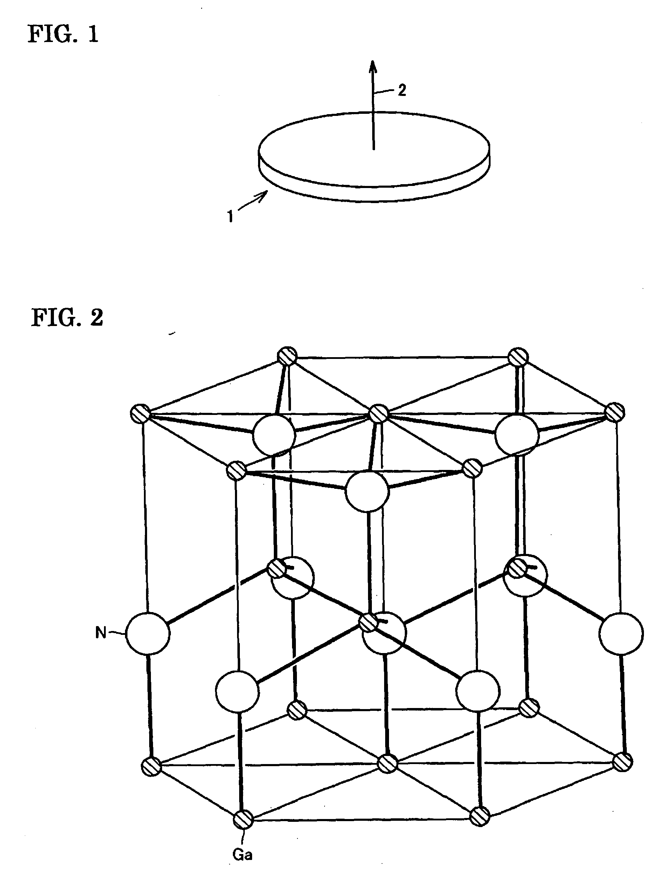

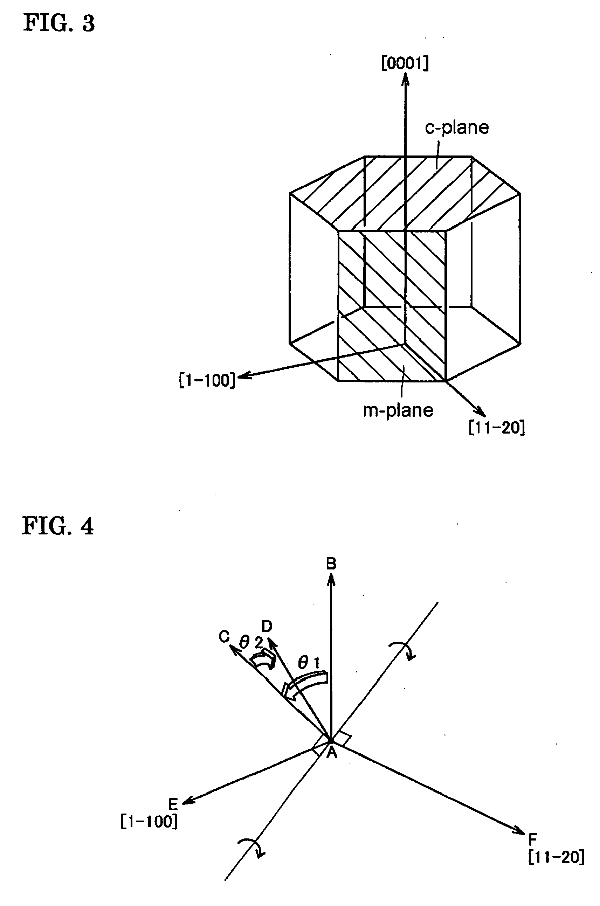

Fig. 1 is a perspective view showing the GaN substrate of the present invention. Fig. 2 is a schematic diagram for explaining the crystal structure of the GaN substrate illustrated in Fig. 1. Fig. 3 is a schematic diagram for explaining plane orientations and crystal planes in the GaN substrate crystal structure illustrated in Fig. 2. Fig. 4 is a schematic diagram for explaining the angles at which the GaN substrate of the present invention illustrated in Fig. 1 is inclined in off-axis directions. Referring to Figs. 1 through 4, the GaN substrate of the present invention will be described.

With reference to Figs. 1 through 4, in a GaN substrate 1 of the present invention, a given plane orientation (here, [0001] plane orientation) is inclined in two different directions (in two off-axis directions) with respect to a normal vector 2 (cf. Fig. 1) of a principal surface of the GaN substrate 1. More specifically, the GaN substrate 1 is the substrate having off-axis angles, and whose [0001] plane orientation is inclined in two different directions.

As illustrated in Fig. 2, GaN crystal has a so-called hexagonal crystallographic structure. In order to more comprehensively describe the symmetry of the GaN hexagonal crystallographic structure, Fig. 2 illustrates the GaN crystallographic structure with a plurality of cells being included. In Fig. 2, big white circles represent nitrogen atomic elements (N atomic elements), and small circles represent gallium atomic elements (Ga atomic elements). On the bottom plane of the crystallographic structure in Fig. 2, one of the nitrogen atomic elements is centrally present, and also at each of apexes of the regular hexagon centered on the central nitrogen atomic element, one of the nitrogen atomic elements is located. The directions that establish links from the centrally present GaN atomic element on the bottom plane to the six atomic elements around the central atomic element is counterclockwise [2-1-10], [11-20], [-12-10], [-2110], [-1-120], [1-210], respectively. These directions are the directions that establish Ga-Ga links. The directions in which any Ga atomic element is not present, seen from the central Ga atomic element on the bottom plane are [1-100] and other directions. In the crystallographic structures Figs. 2 and 3 illustrate, the top plane of hexagonal crystal regarded as a regular cylinder is called *c*-plane, and lateral planes of the regular cylinder are called m-plane.

In the GaN substrate 1 of the present invention illustrated in Fig. 1, the [0001] plane orientation is inclined in two different off-axis directions-that is, the [1-100] and [11-20] plane orientation directions-with respect to the normal vector 2 (cf. Fig. 1). Referring to Fig. 4, the state of the [0001] plane orientation inclination in the GaN substrate 1 with respect to its principal surface normal vector will be explained.

First, the direction represented with vector *AB* is regarded as corresponding to the normal vector 2 (cf. Fig. 1) of the GaN substrate principal surface. Next, from the state in which the GaN substrate [0001] plane orientation coincides with the vector *AB*, the GaN crystal is inclined so that the [0001] plane orientation tilts only at inclination angle of θ*₁* in the direction of vector *AE* corresponding to [1-100] plane orientation. As a result, the GaN [0001] plane orientation is directed to vector *AC.* Subsequently, the GaN crystal structure tilted in the direction represented with the vector *AC* is further inclined only at inclination angle of *θ₂* in the direction of vector *AF* corresponding to [ 11-20] plane orientation. Consequently, in the GaN crystal, the [0001] plane orientation is directed to vector *AD* in Fig. 4.

As just explained, in the GaN substrate 1 of the present invention, with respect to the principal surface normal vector 2 (cf. Fig. 1) represented with the vector *AB*, direction of the [0001] plane orientation has inclined in the direction represented with the vector *AD* (that is, the [0001] plane orientation has inclined in the [1-100] and [11-20] plane orientation directions at the inclination angles respectively of only *θ₁* and θ*₂* with respect to the principal surface normal vector 2).

In the GaN substrate 1 of the present invention, inclining the [0001] plane orientation in such a manner makes the principal surface of the GaN substrate 1 a so-called semipolar surface. Epitaxially growing GaN, InGaN or other layers on the principal surface of this GaN substrate 1 to form light-emitting devices as semiconductor devices more effectively prevents internal electric fields from being generated in the active layer, compared with forming an epitaxial layer on GaN *c*-planes to manufacture light-emitting devices. As a result, the likelihood that, owing to the occurrence of an internal electric field, the implanted electrons and holes will recombine is reduced, and in the influence of problems such as a consequent drop in emission efficiency, or emission wavelength varying according to changes in the applied current can be lessened. For this reason, light-emitting devices having an invariant emission wavelength, and whose emission efficiencies have been heightened can be produced.

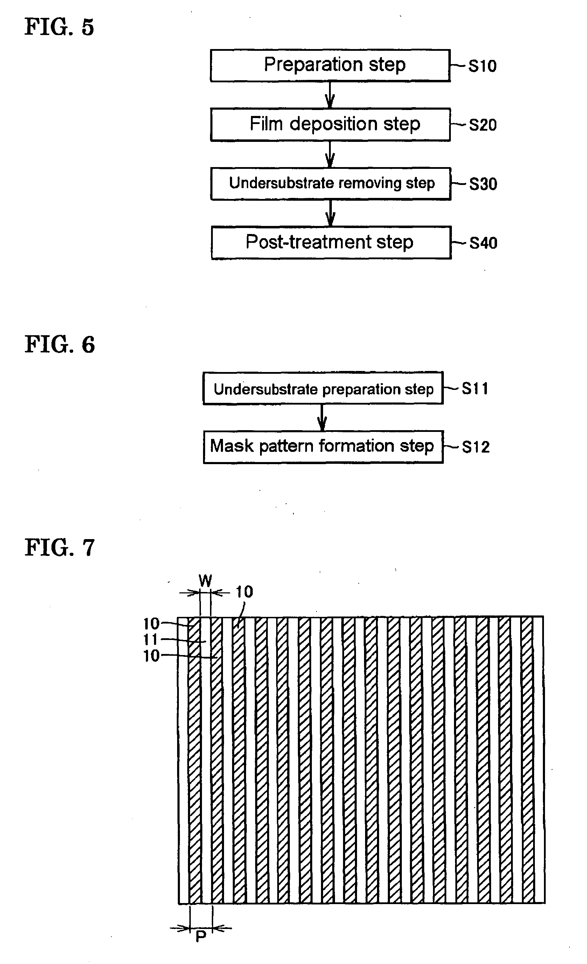

Fig. 5 is a flow chart for explaining the method of manufacturing the GaN substrate illustrated in Fig. 1. Fig. 6 is a flow chart for explaining in detail the preparation step in the flow chart represented in Fig. 5. Referring to Figs. 5 and 6, the GaN substrate manufacturing method of the present invention will be described.

First, a preparation step (*S*10) is carried out with reference to Figs. 5 and 6. In the preparation step (*S*10), an undersubstrate acting as a base for forming a GaN epitaxial layer serving as a GaN substrate is prepared. Specifically, in the preparation step (*S*10) (cf. Fig. 5), as represented in Fig. 6, an undersubstrate preparation step (*S*11) is performed, first. In the undersubstrate preparation step (*S*11), a substrate on whose surface GaN can be epitaxially grown, and to whose principal-surface normal vector a given plane orientation is inclined in two different directions (the inclination directions toward undersubstrate) is prepared.

Herein, the undersubstrate may be composed of any material, as long as a GaN can be deposited onto the undersubstrate surface. As the undersubstrate, gallium arsenide (GaAs), sapphire, zinc oxide (ZnO), silicon carbide (SiC), or GaN substrate cay be utilized, for example. And, the undersubstrate is rendered the substrate having so -called off-axis angles so that in a film deposition step that will be described hereinafter, the GaN epitaxial layer grows with the [0001] plane orientation of the formed GaN epitaxial layer inclining in the two predetermined directions (two off-axis directions) with respect to the normal vector of the undersubstrate principal surface on which the GaN epitaxial layer is formed. Specifically, in the undersubstrate, the predetermined reference or fiducial plane orientation has inclined in the predetermined directions with respect to the normal vector of the undersubstrate principal surface on which the epitaxial layer is formed. As such a substrate, for example, a substrate whose principal surface is a given crystal plane (the *c*-plane, if the substrate is, for example, hexagonal crystal) is prepared, and the undersubstrate is created in a manner of grinding the substrate principal surface at an angle tilting in the predetermined direction with respect to the substrate principal surface, or of slicing off at the predetermined angle a bulk substrate whose crystal plane orientation with respect to the principal surface has been known.

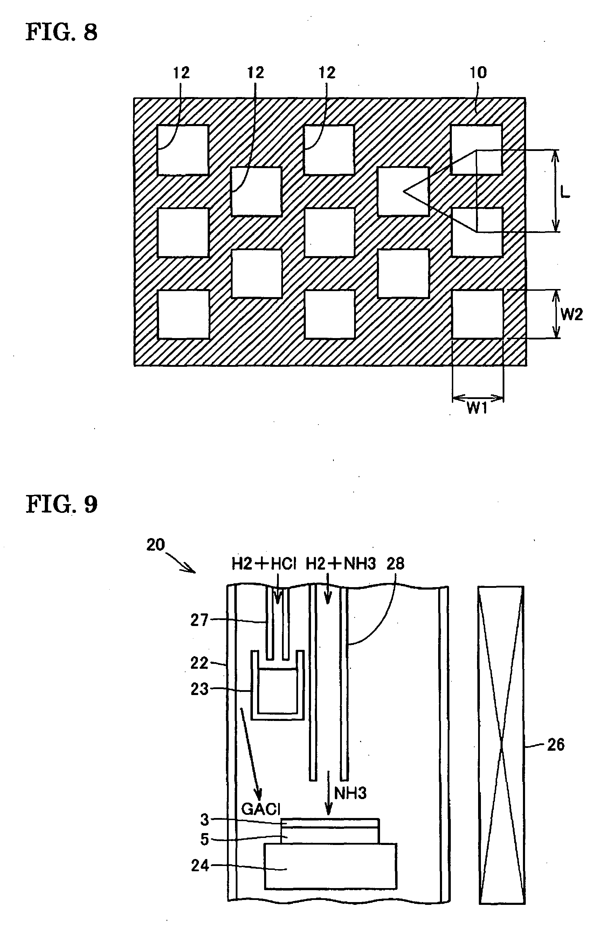

Next, as represented in Fig, 6, a mast patterning step (*S*12) is performed. In the mask pattern formation step (*S*12), a mask is patterned on the undersubstrate principal surface on which the GaN epitaxial layer is formed. More precisely, a mask layer 10 having a pattern as illustrated in Fig. 7 or Fig. 8 is formed. Figs. 7 and 8 are schematic plane views showing mast patterns of a mask layer formed on the undersubstrate principal surface.

First, a mask pattern as illustrated in Fig. 7 will be explained. As the mask layer 10 formed on the undersubstrate principal surface, a mask may be linearly patterned so that a plurality of lines with width of *W*1 extends parallel at pitch *P*, as illustrated in Fig. 7. In such a mask pattern, the pitch *P* can be made 8 *µ*m, the line width *W*1 6 *µ*m, and the inter-line interval *W*2 (width of the trough-like openings 11 formed between the lines) 2 *µ*m. Furthermore, the linear pattern thickness is made 0.1 *µ*m.

As another mask pattern, for example, as illustrated in Fig. 8, the mask layer 10 having a mask patterned as if openings 12 are periodically formed may be utilized. Specifically, as illustrated in Fig. 8, the mask layer 10 in which the openings 12 rectangular in planar form are in a distributed arrangement at a predetermined spacing from each other is formed on the undersubstrate principal surface. The openings 12 may be, for example, square in form, as illustrated in Fig. 8, with spacing L that is a line segment connecting the square centers being 4 *µ*m. Furthermore, lengths *W*1 and *W*2 of sides of the square openings 12 may be each 2 *µ*m. Also, the plurality of openings 12 is arranged in a so-called hound's tooth configuration. In such a configuration, the openings 12 may be arranged so that connecting the centers of the adjacent openings 12 takes the form of regular triangle whose side is the spacing L.

The undersubstrate on which such a mask layer 10 is formed is subjected to a film deposition step (*S*20). Specifically, a GaN thin film is formed by vapor phase epitaxy on the undersubstrate principal surface on which a mask layer has been formed. Examples of vapor phase epitaxy utilized for GaN thin film include hydride vapor phase epitaxy (HVPE), sublimation, metalorganic chloride (MOC), metalorganic chemical vapor deposition (MOCVD). In the film deposition step (*S*20), HVPE is mainly employed. Fig. 9 is a schematic diagram illustrating a film deposition device used in the film deposition step (*S*20). Referring to Fig. 9, the device with which the film is deposited by HVPE will be described.

As illustrated in Fig. 9, a film deposition device 20 is provided with: a reactor tube 22; a Ga boat 23 disposed inside the reactor tube 22; a susceptor 24 for supporting the undersubstrate in the reactor tube 22; and a heater 26 for heating the interior of the reactor tube 22. In the Ga boat 23, a Ga metal is placed. In addition, a supply line 27 for feeding hydrochloric (HCl) gas diluted with hydrogen, nitrogen, or argon is arranged so as to head toward the Ga boat 23. A supply line 28 for supplying an ammonia (NH₃) gas diluted with hydrogen, nitrogen, or argon is disposed above the susceptor 24. The heater 26 for heating the reactor tube 22 is disposed at the position opposing the outer periphery of the reactor tube 22. An undersubstrate 5 is placed on the susceptor 24. A GaN crystal layer 3 is formed on the undersubstrate 5, as will be described hereinafter.

Next, how to form the GaN crystal layer 3 employing the film deposition device 20 illustrated in Fig. 9 will be described. First, the undersubstrate 5 is placed on the susceptor 24 inside the reactor tube 22 in the film deposition device 20 illustrated in Fig. 9. Subsequently, the Ga boat 23 that is a vessel interiorly containing a Ga metal is arranged above the susceptor 24. Successively, with the film deposition device 20 being entirely heated with the heater 26, the hydrochloric (HCl) gas diluted with hydrogen, nitrogen, or argon is jetted out via the supply lint 27 into the Ga boat 23. As a result, the reaction of 2Ga + 2HCl → 2GaCl + H₂ occurs. Gaseous GaCl generated from this reaction is supplied to the undersubstrate 5.

Simultaneously, the ammonia (NH₃) gas diluted with hydrogen, nitrogen, or argon is supplied via the supply line 28 to the vicinity of the susceptor 24. Consequently, the reaction of 2GaCl + 2NH₃ → 2GaN + 3H₂ occurs in the proximity of the undersubstrate 5. GaN formed from such a reaction is laminated as GaN crystal on the surface of the heated undersubstrate 5. As just described, the GaN crystal layer 3 is formed on the surface of the undersubstrate 5. In forming the GaN crystal layer 3, on the undersubstrate surface, the GaN crystal layer 3 is formed on the mask layer 10 as illustrated in Figs. 7 and 8. As a result, dislocation density of the formed GaN crystal layer 3 can be reduced.

Furthermore, because the undersubstrate 5 is the substrate having off-axis angles, also in the formed GaN crystal layer 3, the predetermined plane orientation is inclined with respect to the normal vector of a crystal layer surface opposing the principal surface of the undersubstrate 5. Moreover, the inclination directions and angles of the predetermined plane orientation in the GaN crystal layer 3 with respect to above normal vector are variable depending on the directions and angles of the fiducial orientation inclination in the undersubstrate.

Herein, the GaN crystal layer 3 is formed thickly enough to be independently treated even after the undersubstrate 5 is removed, as will be described hereinafter. Thickness of the GaN crystal layer 3 can be brought to the extent of 10 mm, for example.

Next, as represented in Fig. 5, a undersubstrate removing step (*S*30) is carried out. In the undersubstrate removing step (*S*30), the undersubstrate 5 is removed from the formed GaN crystal layer 3. As how to remove the undersubstrate 5, any of mechanical methods such as slicing, chemical methods such as etching, and electrochemical methods such as electrolytic etching can be utilized. As a result of removing the undersubstrate 5, a GaN substrate composed of the GaN crystal layer 3 is produced. Depending on the fact that in the undersubstrate, the fiducial plane is inclined in two directions, in a produced GaN substrate 1 (cf. Fig. 1), the [0001] plane orientation has inclined in two different off-axis directions with respect to the undersubstrate fiducial plane.

Subsequently, a post-treatment step (*S*40) is carried out. As the post treatment step (*S*40), a process of polishing substrate surface, a process of slicing the GaN substrate 1 to the predetermined thickness, or other processes can be performed.

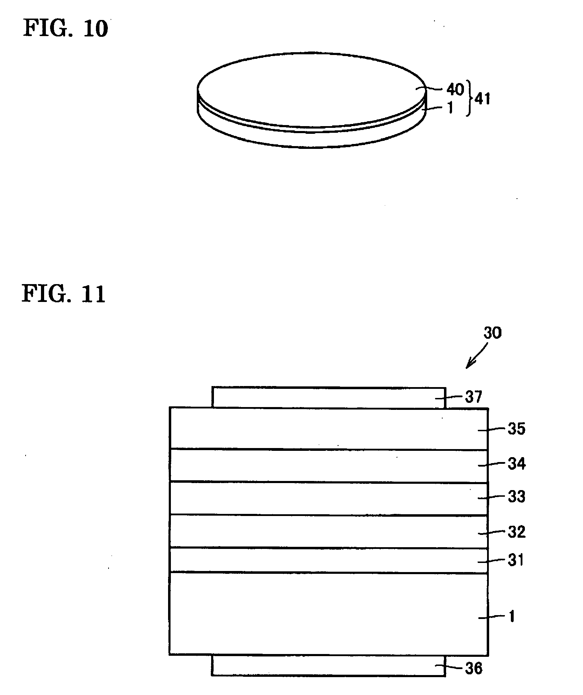

As illustrated in Fig. 10, a substrate with an epitaxial layer (epi-substrate 41) can be obtained by forming an epitaxial layer 40 such as GaN on the surface of the GaN substrate 1 produced in above manner. Fig. 10 is a perspective schematic diagram illustrating the epi-substrate in which the GaN substrate of the present invention is employed. Furthermore, with such an epi-substrate 41, a light-emitting device can be formed as illustrated in Fig. 11. Fig. 11 is a schematic cross-sectional view showing the light-emitting device employing the GaN substrate of the present invention. Referring to Fig. 11, the light emitting device employing the GaN substrate of the present invention will be explained.

As illustrated in Fig. 11, in a light emitting device 30 as a semiconductor device, an n-type AlGaN interlayer 31 is formed on the GaN substrate 1. On the n-type AlGaN interlayer 31, an *n*-type GaN buffer layer 32 is formed. On the *n*-GaN buffer layer 32, an emission layer 33 is formed. The emission layer 33 is, for example, an InGaN/InGaN-MQW (multiple quantum well) layer. A *p*-type AlGaN layer 34 is formed on the emission layer 33. On the *p*-type AlGaN layer 34, a *p*-type GaN buffer layer 35 is formed. In addition, an *n*-electrode 36 is formed on the back side of the GaN substrate 1 (on the surface opposite from the substrate front side on which the *n*-type AlGaN interlayer 31 is formed). And, a p-electrode 37 is formed on the p-type GaN buffer layer 35.

Employing the GaN substrate 1 of the present invention to form light-emitting devices diminishes a piezoelectric field in the emission layer because the emission layer 33 is formed on the so-called semipolar surface of the GaN substrate 1. For this reason, in such light-emitting devices, emission efficiency in emission layer is made higher, and the amount of emission wavelength shift caused by variation of the applied current amount is made smaller, than in the conventional light-emitting devices in which an emission layer is formed on GaN substrate polar surface.

Although partially overlapped with the embodiment described above, one example will be cited after another to explain other embodiments of the present invention.

The GaN substrate 1 (cf. Fig. 1) in one aspect of the present invention has a principal surface, with the [0001] plane orientation inclining to the principal surface normal vector 2 in two different off-axis directions.

Such a GaN substrate 1 enables forming, with the principal surface of the GaN substrate 1 being made semipolar by inclining the [0001] plane orientation in the first off-axis direction, an epitaxial layer 40 on the principal surface. Therefore, in light-emitting devices whose emission wavelengths are in a range of long wavelength of 500 nm or more, such epitaxial layer formation makes emission efficiency higher, and makes the amount of emission wavelength shift caused by the variation of the amount of applied current smaller, than forming an epitaxial layer on a polar surface such as the (0001) plane of the GaN substrate 1 to manufacture LEDs and other light-emitting devices. Additionally, further inclining the [0001] plane orientation in the second off-axis direction makes it possible to control the fluctuations of off-axis angle distribution, and of in-plane wavelength distribution of the principal surface of the GaN substrate 1. Moreover, the GaN substrate back side has almost the same off-axis angles as the substrate front side. For this reason, the conductivity of the electrodes formed on the front and back sides is heightened, and increase of operating voltage from the beginning of the operation is lessened. As a result, employing the GaN substrate 1 enables stable manufacturing of light-emitting devices and other semiconductor devices having outstanding properties.

In the GaN substrate 1, the two off-axis angles at which the [0001] plane orientation is inclined with respect to the principal surface normal vector 2 may be [1-100] and [11-20] directions. With the two off-axis angles being [1-100] and [11-20] directions, the principal surface of the GaN substrate 1 being made semipolar enables manufacturing light-emitting devices (semiconductor devices) whose emission efficiencies in a long wavelength range have been enhanced, and enables controlling unfailingly in-plane wavelength fluctuation caused when an epitaxial layer is formed on GaN substrate principal surface.

In the GaN substrate 1, one of the angles at which the [0001] plane orientation is inclined with respect to the normal vector of the substrate principal surface in the [1-100] and [11-20] directions may be between 10° and 40° inclusive, with the other being from 0.02° to 40° inclusive. Furthermore, with one of the two inclination angles being from 10° to 40° inclusive, the other may be from 0.02° and 10° inclusive. Such inclination angles making the GaN substrate principal surface semipolar enables manufacturing light-emitting devices (semiconductor devices) whose emission efficiencies in a long wavelength range have been enhanced, and enables controlling unfailingly in-plane wavelength fluctuation caused when an epitaxial layer is formed on GaN substrate principal surface.

The substrate with an epitaxial layer (epi-substrate 41) according to the present invention is provided with the GaN substrate 1, and an epitaxially grown layer (epitaxial layer 40). In such a substrate, the epitaxial layer is formed on the semipolar surface of the GaN substrate 1, and thus the epi-substrate 41 from which semiconductor substrates such as light-emitting devices whose emission wavelength is included in a range of long wavelength of 500 nm or more, and whose emission efficiencies are enhanced can be stably manufactured.

A semiconductor device (light-emitting device) according to the present invention is manufactured employing the epi-substrate 41. Employing the epi-substrate 41 makes it possible to obtain the light emitting device whose emission wavelength is included in a range of long wavelength of 500 nm or more, and whose emission efficiency is enhanced, with a slight amount of wavelength shift caused by variations in applied electric current.

The GaN substrate manufacturing method according to the present invention is provided with the following steps. That is, initially, a step (undersubstrate preparation step (*S*11)) of preparing an undersubstrate in which the fiducial plane is inclined in the two different inclination directions with respect to the undersubstrate principal surface is carried out. A step (film deposition step (*S*20)) of growing the GaN crystal layer 3 on the principal surface of the undersubstrate 5 is performed. A step (undersubstrate removing step (S30)) of removing the undersubstrate 5 from the GaN crystal layer 3 to produce the GaN substrate 1 composed of the GaN crystal layer 3 is carried out. The GaN substrate 1 has a principal surface, with the [0001] plane orientation inclining in the two different off-axis directions with respect to the principal surface normal vector. By changing one of the angles at which in undersubstrate, fiducial orientation is inclined in the inclination directions toward undersubstrate, the angles at which in GaN substrate, the [0001] plane orientation is inclined in the off-axis angles are adjusted. The inclination directions toward undersubstrate may orthogonally intersect with each other in the undersubstrate. Also, the two off-axis directions may orthogonally intersect with each other. Such an adjustment makes it possible to readily obtain the GaN substrate 1 according to the present invention. Furthermore, by varying the angles at which the fiducial plane of the undersubstrate 5 is inclined in the inclination directions toward undersubstrate, the GaN substrate 1 in which the inclination angles in the off-axis directions has been changed to any angles can be readily manufactured.

In above GaN substrate manufacturing method, the undersubstrate 5 may be a GaAs substrate, and the fiducial plane orientation may be [111]. The two inclination directions toward undersubstrate may be <1-10> and <11-2> directions. The two directions along the misorientation angles in GaN substrate may be [1-100] and [11-20] directions. In such a manufacturing method, because by employing GaAs substrate, which is readily available comparatively, the GaN substrate 1 of the present invention can be produced, the reduction of GaN substrate manufacturing cost is attempted.

In the GaN substrate manufacturing method, the undersubstrate 5 may be a sapphire substrate, and the fiducial plane orientation may be [0001]. The two inclination directions toward undersubstrate may be [11-20] and [1-100] directions. The two off-axis directions of the GaN substrate may be [1-100] and [11-20] directions. In such a manufacturing method, because by employing sapphire substrate, which is readily available comparatively, the GaN substrate of the present invention can be produced, the reduction of GaN substrate manufacturing cost is attempted.

In above GaN substrate manufacturing method, the undersubstrate 5 may be a ZnO substrate, and the fiducial plane orientation may be [0001]. The two inclination directions toward the undersubstrate may be [1-100] and [11-20] directions. The two off-axis directions of the GaN substrate may be [1-100] and [11-20] directions. In such a manufacturing method, because by utilizing as the undersubstrate 5 a ZnO substrate, which is readily available comparatively, the GaN substrate 1 of the present invention can be produced, the reduction of GaN substrate manufacturing cost is attempted.

In the GaN substrate manufacturing method, the undersubstrate 5 may be a SiC substrate, and the fiducial plane orientation may be [0001]. The two inclination directions toward undersubstrate may be [1-100] and [11-20] directions. The two off-axis directions of the GaN substrate 1 may be [1-100] and [11-20] directions. In such a manufacturing method, because by utilizing as the undersubstrate 5 a SiC substrate, which is readily available comparatively, the GaN substrate 1 of the present invention can be produced, the reduction of GaN substrate manufacturing cost is attempted.

In the GaN substrate manufacturing method, the undersubstrate 5 may be a substrate composed of GaN, and the fiducial plane orientation may be **[0001].** The two inclination directions toward undersubstrate may be [1-100] and [11-20] directions. The two off-axis directions of the GaN substrate 1 may be [1-100] and [11-20] directions. In such a manufacturing method, by utilizing as the undersubstrate 5 for forming a GaN crystal layer to be the GaN substrate 1, the substrate composed of GaN that is the same material as that for the GaN crystal layer, membranous of the GaN crystal layer 3 can be heightened. The GaN substrate 1 of sufficient membranous can be obtained.

The GaN substrate manufacturing method may be further provided with a step (mask pattern formation step (*S*12)) of, prior to the film deposition step (*S*20)) of growing a GaN crystal layer, forming on the principal surface of the undersubstrate 5 a mask layer having a plurality of windows. In such a manufacturing method, GaN crystals grow on the parts of the principal surface of the undersubstrate 5 which are exposed from the windows (openings 12) of the mask layer 10, and then on the mask layer 10, the GaN crystals laterally grow. Furthermore, the GaN crystals laterally growing from above the adjacent openings 12 collide with each other, and then grow in the (upward) direction orthogonal to the surface of the mask layer 10, to reduce dislocation density of the GaN substrate 1. Therefore, dislocation density of the GaN substrate 1 is reduced, and industrially effective GaN substrate having a large diameter of 2 inches or more with no clacks can be produced.

In the GaN substrate manufacturing method, in the undersubstrate 5, one of the inclination angles in the two inclination directions toward undersubstrate is between 10° and 40° inclusive, and the other is between 0.02° and 40° inclusive. In this situation, in the GaN substrate 1, the inclination angles in the two off-axis directions are adjustable to between 10° and 40° inclusive, and to between 0.02° and 40° inclusive.

### Embodiment 1

Next, in order to confirm the effects of the present invention, the following experiment was carried out. Namely, a GaN substrate in accordance with the present invention was prepared, and a light-emitting device utilizing the GaN substrate was produced. Subsequently, as to the GaN substrate and light-emitting device, the relationship between the wavelength of emitted light and the amount of supplied electric current was measured, as will be described hereinafter. Furthermore, for comparison, the first GaN substrate whose principal surface was rendered *c*-plane, and the second GaN substrate whose principal surface was rendered m-plane were prepared, and light-emitting devices as comparative examples were formed employing these GaN substrates. Subsequently, as to these comparative light-emitting devices, the properties similar to those of the first and second GaN substrates were measured. The experiment will be described in detail hereinafter.

### 1. Preparation of GaN substrate

### 1-1. Preparation of GaN substrate of the present invention

Undersubstrate:
As the undersubstrate, a GaAs substrate was utilized. However, a GaAs substrate having diameter of 2 inches, and whose [111] plane orientation inclined at 18° in the <1-10> direction, and at 0.03° in the <11-2> direction, with respect to the substrate surface was used. And, a mask layer having stripe pattern as illustrated in Fig. 7 was formed on the undersubstrate surface. The mask layer is composed of oxide silicon (SiO₂). In the mask layer 10, the width *W* of the stripes in the linear pattern was let be 6 µm, the width W of the openings was let be 2 *µ*m, and stripe pitch Pin the linear pattern was let be 8 *µ*m. Furthermore, thickness of the mask layer 10 is made 0.1 *µ*m.

Conditions for film deposition:
On the surface of the undersubstrate described above, a GaN crystal layer was formed under the following conditions. Namely, with the film deposition device as illustrated in Fig. 9, the GaN crystal layer was formed on the undersubstrate surface by HVPE. During the process of growing GaN crystal on the undersubstrate surface, a thin buffer layer was grown at a relatively low temperature, first. Subsequently, a thick GaN epitaxial layer was grown at a relatively high temperature. It was made the conditions for the buffer layer deposition that: the temperature at which film was deposited was 500°C; HCl partial pressure was 1 x 10⁻³ atm (100 Pa); NH₃ partial pressure was 0.1 atm (10000 Pa); time required to film deposition was 60 minutes; and thickness of the deposited buffer layer was 60 nm. Furthermore, it was made the conditions for depositing the deposition of the GaN epitaxial layer formed on the buffer layer that: the temperature at which film deposition was performed was 1030°C; HCl partial pressure was 3 x 10⁻² atm (3000 Pa); NH₃ partial pressure was 0.2 atm (20000 Pa); time required to perform film deposition while Si doping as n-type dopant was 100 hours; and thickness of the deposited epitaxial layer was 10 mm.

Successively, the GaAs substrate was removed with a mechanical grinding machine from the deposited GaN film. As a result, 10 mm-thick freestanding GaN substrate was created. The GaN substrate was sliced to be 400 *µ*m in thickness, and subjected to surface polishing, to obtain 10 GaN substrates 2 inches in diameter.

### 1-2. Preparation of comparative substrates

GaN substrate whose principal surface is *c*-plane:
Although basically produced in the same manner as that of producing the GaN substrate of the present invention described above, a GaN substrate whose principal surface was *c*-plane differs from the GaN substrate of the present invention in that the [111] plane orientation of the GaAs substrate utilized as undersubstrate parallels the normal vector of the GaAs substrate. As a result of employing such an undersubstrate, in the obtained freestanding GaN substrate, the principal-surface normal vector parallels the [0001] plane orientation, and the principal surface parallels the (0001) face (*c*-plane).

GaN substrate whose principal surface is *m*-plane:
Orthogonally to the principal surface of the GaN substrate whose principal surface was *c*-face, a 400 *µ*m -thick substrate was sliced off from the GaN substrate to prepare a GaN substrate whose principal surface is made m-plane.

### 2. Formation of light-emitting device

By superficially depositing epitaxial layers onto the GaN substrates obtained by the present embodiment of the invention and by the comparative examples, and furthermore by forming the electrodes and dividing the substrates into devices, light-emitting devices as illustrated in Fig. 11 were formed. Herein, in the light-emitting devices, thickness of the n-type AlGaN interlayer 31 was brought to 50 nm, thickness of the *n*-type GaN buffer layer 32 was made 2 *µ*m, thickness of the emission layer 33 was made 50 nm, thickness of the *p*-type AlGaN layer 34 was made 20 nm, and thickness of the *p*-type GaN contact layer 35 was made 50 nm. Furthermore, for the *n*-electrode 36, Al/Ti was utilized, and Al and Ti were made respectively 500 nm and 50 nm in thickness. Furthermore, for the *p*-type electrode 37, Pt/Ti was utilized as material, and the Pt and Ti were made respectively 500 nm and 50 nm in thickness. The *n*-type electrode additionally may be Au/Ge/Ni (respectively 500 nm, 100 nm, and 50 nm in thickness), Pt/Ti (respectively 500 nm and 50 nm in thickness), or Au/Ti (respectively 500nm and 50 nm in thickness), and the *p*-electrode may be Pt (500 nm in thickness), or Ni (500 nm in thickness). These light-emitting devices emit light in the green region in which wavelength is longer than in green region, because they include InGaN as the emission layer 33.

### 3. Measurement

As to the GaN substrates produced in above manner, their off-axis angles (the inclination directions and angles of the [0001] plane orientation is inclined with respect to the GaN substrate principal-surface normal vector) were measured. Also, in-plane distribution of the off-axis angles was measured. Additionally, dislocation densities of the GaN substrates were measured. Moreover, the relationship between the emission wavelength and the electric-current amount in the formed light-emitting devices was measured.

### 3-1. Measuring method

Measurement of GaN substrate off-axis angle and its distribution:
The GaN substrate off-axis angles were measured in a slit of 200 *µ*m square with a two-crystal x-ray diffraction (XRD) system. Furthermore, in measuring the off-axis angle distribution, as to the GaN substrates principal surface, the off-axis angles were measured at a total of 5 points-that is, the substrate central point and four points 200mm away from the central point in the <1-100> and <11-20> directions. The maximum absolute value of differences between the angle at the central point and the angles at the four points 20 mm away from the central point was rendered value of the off-axis angle distribution. Precision of measurement by XRD is ±0.01.

Measurement of GaN substrate dislocation density:
As to the GaN substrates, with cathodoluminescence (CL) employing SEM, measurement was performed by counting dark dots within a 100 *µ*m square at the same 5 points as in XRD.

Measurement of emission wavelength from and amount of current supplied to light-emitting-devices:
While the level of the current supplied to the prepared light-emitting devices was varied, the wavelength of light output from the devices was measured at the same time. Specifically, a pulsed current was applied to the light-emitting devices at room temperature and the emission spectra were measured.

### 4. Measurement results

GaN substrate off-axis angle:
As to the GaN substrate off-axis angles, the measurement results demonstrated an off-axis angle at which the [0001] plane orientation is inclined in the [11-20] direction at approximately 18° with respect to the substrate surface normal vector. The results also demonstrated an off-axis angle inclined about 0.05° in the [1-100] direction. Furthermore, in-plane distribution of the off-axis angles in the [11-20] direction was in the range of ±0.5° (-17.5 to 18.5°) in the substrate surface. Moreover, in-plane distribution of the off-axis angles in the [1-100] direction is in the range of ±0.3° in the substrate surface.

GaN substrate dislocation density:
As a result of measuring GaN substrate dislocation density, all the test samples demonstrated dislocation density of 1 x 10⁷ (/cm²) or less.

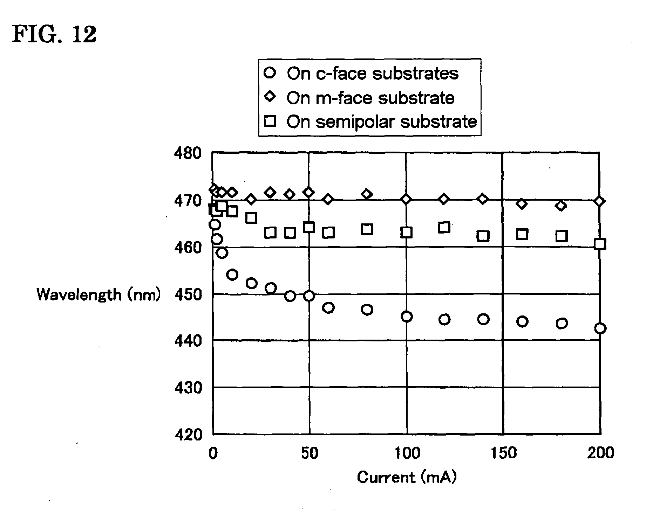

Relationship between the wavelength of emitted light from light-emitting device and the amount of applied electric current:
Results are set forth in Fig. 12. Fig. 12 is a graph plotting relationships between the electric current supplied to the light-emitting devices and the wavelength of emitted light. As is apparent from Fig. 12, the relationship between the emission wavelength of a light-emitting device of the embodiment of the present invention and the amount of current is that although the wavelength of light given out shifts toward shorter wavelengths as the amount of current supplied to the light-emitting device grows larger, the extent of the shift was at about the 7 nm level. Compared with the fact that the extent of wavelength shift in conventional GaN substrates-that is, the comparative GaN substrate produced employing the *c*-plane substrate whose surface parallels the GaN *c*-plane-is approximately 20 nm, the extent of shift in the light-emitting device of the embodiment of the present invention is lessened. Herein, in the comparative light-emitting device produced employing the m-plane substrate represented in Fig. 12, wavelength shift only slightly occurs. The possible cause is that due to the fact that the m-plane is non-polar, no internal electric field is generated in the emission layer.

### Embodiment 2

In order to confirm the effectiveness of the present invention, the following experiment was carried out. Specifically, GaN substrates: test sample ID Nos. 1 to 70 were prepared, and as to these GaN substrate test samples, off-axis directions, off-axis angles, and furthermore, off-axis angle in-plane distribution, and dislocation density were measured. Moreover, light-emitting devices were formed employing the GaN substrates to measure the amount of emission wavelength change (blue shift: Δλ) caused by varying the electric current applied to the light-emitting devices, the amount of increase in operating voltage *(ΔVₒₚ)* when 1000 hours passed, and emission wavelength distribution (σ) in the GaN substrate surface. Below, the experiment will be described in detail.

### 1. GaNsubstrate preparation

As to all the test samples (test sample ID Nos. 1 to 70), GaN substrates were prepared by employing the basically same manner as in Embodiment 1 described above.

Undersubstrate:
As to the test samples ID Nos. 1 to 65, GaAs substrates were utilized as the undersubstrate for forming GaN substrates, and on the other hand, as to the test samples ID Nos. 66 to 70, substrates composed of material other than GaAs were utilized as the undersubstrate. Specifically, as undersubstrate, sapphire substrates were used for test samples ID Nos. 66 and 67, and ZnO, SiC, and GaN substrates were used for the test samples: ID Nos. 68 to 70. In the undersubstrates, the (off-axis) angles at which the [0001] plane orientation is inclined in two directions with respect to the normal vector of the substrate principal surface on which a GaN crystal film was formed were appropriately arranged so that the off-axis directions of the formed GaN substrates are two directions.

More precisely, in the GaAs substrates, the [111] plane orientation is inclined in the <1-10> and <11-2> directions with respect to the substrate-principal-surface normal vector so that the GaN [0001] plane orientation is inclined in the [11-20] and [1-100] directions with respect to the surface of the GaN crystal film to be formed. The inclination angles (off-axis angle θ*₁* in the <1-10>, and off-axis angle θ*₂* in the <11-2> direction) in the (off-axis) directions were varied depending on the test samples.

Furthermore, in the sapphire substrates, the [0001] plane orientation is inclined in the [11-20] and [1-100] directions with respect to the substrate-principal-surface normal vector so that the GaN [0001] plane orientation is inclined in the [1-100] and [11-20] directions with respect to the surface of the GaN crystal film to be formed. The inclination angles (off-axis angles θ*₁* in the [11-20] direction, and θ*₂* in the [1-100] direction) in the (off-axis) directions were arranged to be θ*₁* = *θ₂* = 26° for the test sample: ID No. 66, and to be θ*₁* = *θ₂ =* 40° for test sample ID No. 67.

Moreover, in the ZnO substrates, the [0001] plane orientation is inclined in the [1-100] and [11-20] directions with respect to the substrate-principal-surface normal vector. The inclination angles (off-axis angle θ*₁* in the [1-100] direction, and off-axis angle θ*₂* in the [11-20] direction) in the (off-axis) directions were arranged to be θ*₁* = *θ₂* = 26°.

Also in the SiC substrates, the [0001] plane orientation is inclined in the [1-100] and [11-20] directions with respect to the substrate-principal-surface normal vector. The inclination angles (off-axis angle θ*₁* in the [1-100] direction, and off-axis angle θ*₂* in the [11-20] direction) in the (off-axis) directions were arranged to be *θ₁* = *θ₂=* 26°.

Additionally, in the GaN substrates, the [0001] plane orientation is inclined in the [1-100] and [11-20] directions with respect to the substrate-principal-surface normal vector. The inclination angles (off-axis angle θ*₁* in the [1-100] direction, and off-axis angle θ*₂* in the [11-20] direction) in the (off-axis) directions were arranged to be θ*₁* = θ*₂*= 26°.

Furthermore, for all the test samples: ID Nos. 1 to 70, a mask layer having a striping pattern illustrated in Fig. 7 was formed on the undersubstrate principal surfaces, as in Embodiment 1. The mask layer thickness and striping pattern size are the same as those of the mask layer in Embodiment 1.

Conditions for film deposition:
On the surfaces of the undersubstrates described above, a GaN crystal layer was formed under the conditions demonstrated in Tables I through XIV. That is, with the film deposition device 20 as illustrated in Fig. 9, the GaN crystal layer was formed on the undersubstrate surfaces by HVPE. During the process of growing GaN crystal on the undersubstrate surfaces, a thin buffer layer was grown at a relatively low temperature, first. Subsequently, on the buffer layer, a thick GaN epitaxial layer was grown at a relatively high temperature. The conditions under which the buffer layer was deposited were defined as demonstrated in Tables I through XIV that will be described hereinafter. Herein, in the test samples: ID. No. 70 in which the substrate composed of GaN was utilized as undersubstrate, the buffer layer growth was omitted, and a GaN epitaxial layer was grown directly on the undersubstrate.

After the film deposition, the GaAs and other under substrates were removed by grinding from the deposited GaN films. In this procedure, 10 mm-thick freestanding GaN substrates were produced. Successively, the GaN substrates were sliced off with a wire saw to be thickness of 400 *µ*m, and superficially polished to obtain 10 GaN substrates having diameter of 2 inches. ***2. Light-emitting device formation***

By superficially depositing epitaxial layers onto the obtained GaN substrate test samples ID Nos. 1 through 70, and furthermore, by forming the electrodes and dividing the substrates into devices, light-emitting devices as illustrated in Fig. 11 were formed. Herein, the composition and thickness of each of the layers in the light-emitting devices were made the same as those of the light-emitting devices of Embodiment 1.

### 3. Measurement

As to the GaN substrates produced in above manner, the substrate off-axis angles-that is, the angle (off-axis angle θ*ₐ*) at which the [0001] plane orientation is inclined in the [1-100] direction, and the angle (off-axis angle θ*_{b}*) at which the [0001] plane orientation is inclined in the [11-20] direction, with respect to the GaN substrate-surface normal vector-were measured. In addition, in-plane distribution of the off-axis angles was measured. Also, as to the GaN substrates, dislocation density was measured. Furthermore, as to the formed light-emitting devices, the relationship between the emission wavelength and the amount of electric current was measured. Below, how to measure the data will be described.

Measurement of GaN substrate off-axis angles and their distribution:
The GaN substrate off-axis angles were measured with XRD system in the same manner as in Embodiment 1. The in-plane distribution of the GaN substrate off-axis angles was also measured in the same manner as in Embodiment 1.

Measurement of GaN substrate dislocation density:
As to the GaN substrates, dislocation density was measured with CL equipped to the SEM in the same measuring manner as in embodiment 1.

Measurement of the amount of change in emission wavelength of the light-emitting devices (blue shift: Δλ):
As to the produced light-emitting devices, applied electric current was being varied, and at the same time, wavelength of light emitted from the light-emitting devices was measured. The specific measuring way was the same as in Embodiment 1. And, difference between the wavelength of light emitted when electric current supplied to the light-emitting devices were made sufficiently great (specifically, 200 mA) and the wavelength of light emitted at electric current of 10 mA was rendered blue shift *Δλ* (units: nm).

Measurement of the amount of increase (Δ *Vₒₚ*) in light-emitting device operating voltage at the point when 1000 hours passed
As to the produced light-emitting devices, voltage required to distribute electric current of 100 mA through the light-emitting devices at temperature of 80°C was measured as operating voltage at the beginning of operation and after 1000-hour operation, and the amount of increase in operating voltage was rendered *ΔVₒₚ* (units: V).

Measurement of emission wavelength distribution in GaN substrate surface:
As to the GaN substrates on whose surfaces an epitaxial layer was formed in order to form light-emitting devices, in-plane wavelength distribution was measured. In the specific measuring way, after an *n*-electrode was formed on the GaN substrate back sides, and a *p*-electrode was formed on the epitaxial layer, 10 light-emitting devices of 500 µm square were taken from each of a total of five points-one of which was the substrate central point, and four of which were each 20 mm away from the central point in the <1-100> and <11-20> directions. Pulse current was applied to the 50 resultant light-emitting devices to measure emission spectrum, and average emission wavelength at each of the points was calculated. Subsequently, among the emission wavelength averages (5 data) at the central point and the other four points, the maximum absolute value of the difference between the 5 data was rendered the wavelength distribution (unit: nm).

### 4. Measurement results

The measurement results are shown below.

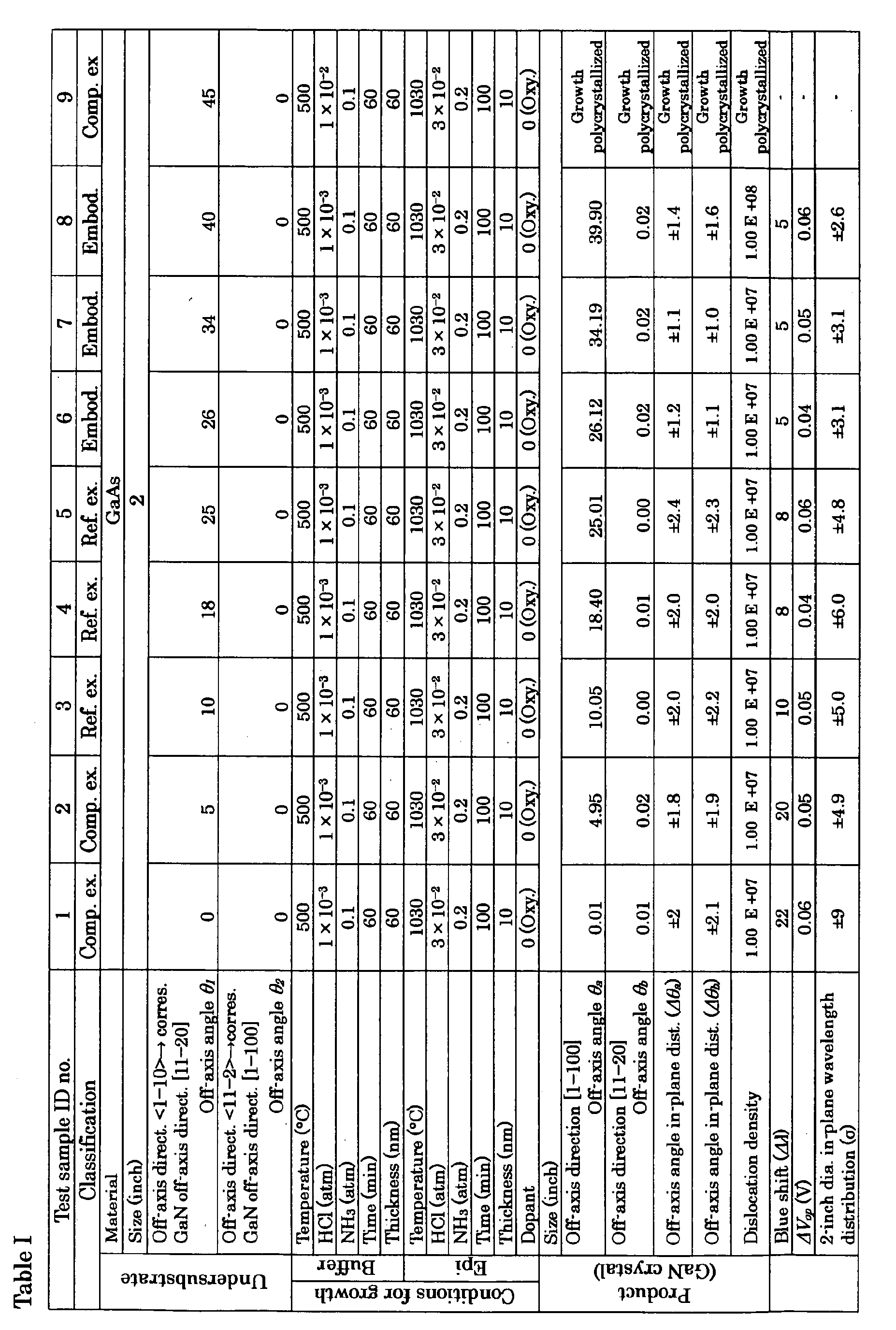

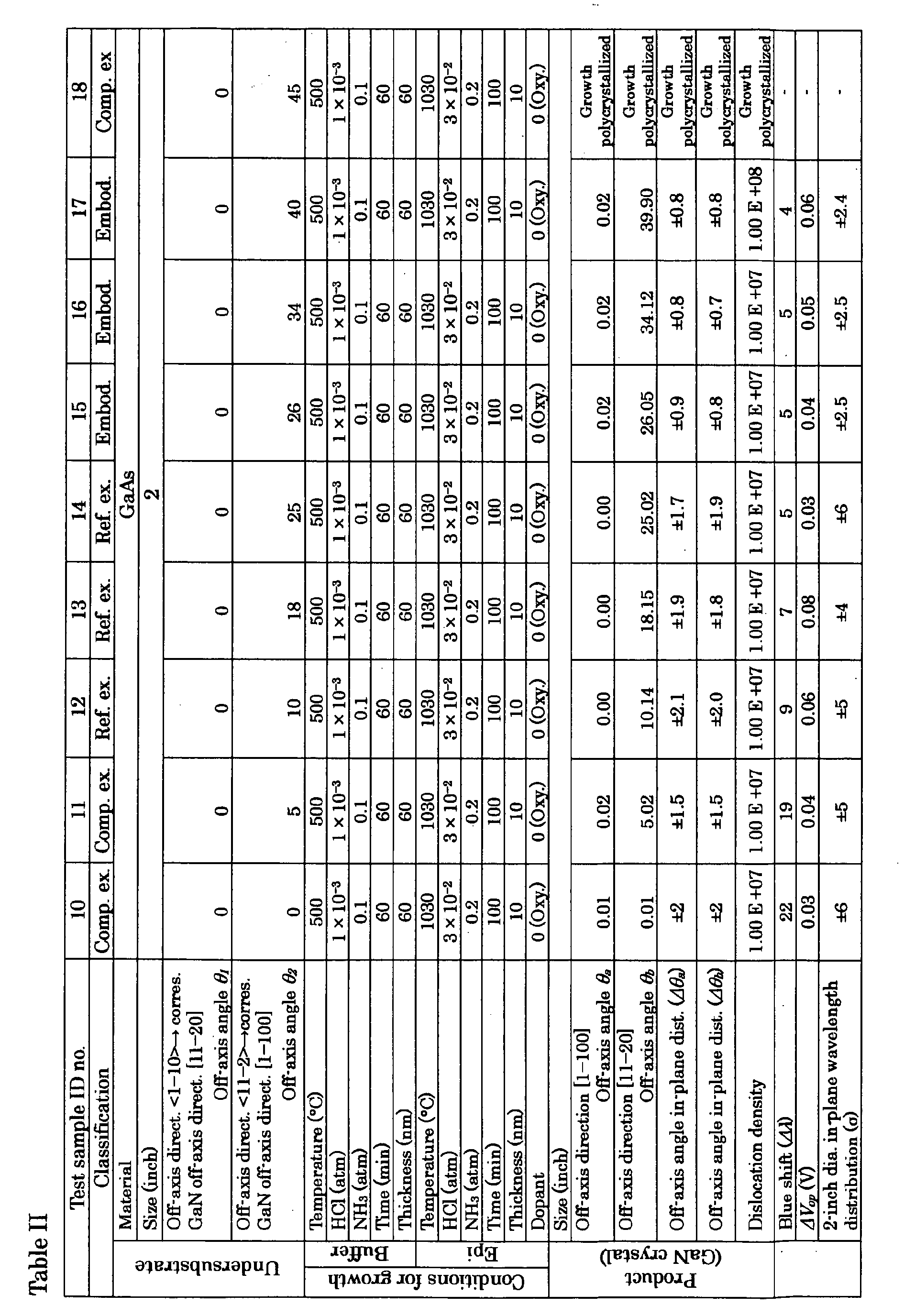

In the undersubstrates of the test samples: ID Nos. 1 through 18, the [111] plane orientation was inclined in just one direction (the <1-10> or <11-2> direction) with respect to the principal-surface normal vector. As a result, in the formed GaN substrates, the [0001] plane orientation basically is inclined greatly in the [11-20] or [1-100] direction with respect to the principal-surface normal vector.

As Tables I and II demonstrate, bringing the undersubstrate off-axis angle θ*₁* or θ*₂* to between 10° to 40° inclusive (that is, bringing the GaN substrate off-axis angle θ*ₐ* or *θ_{b}* to between 10° to 40° inclusive) lessens the blue shift.

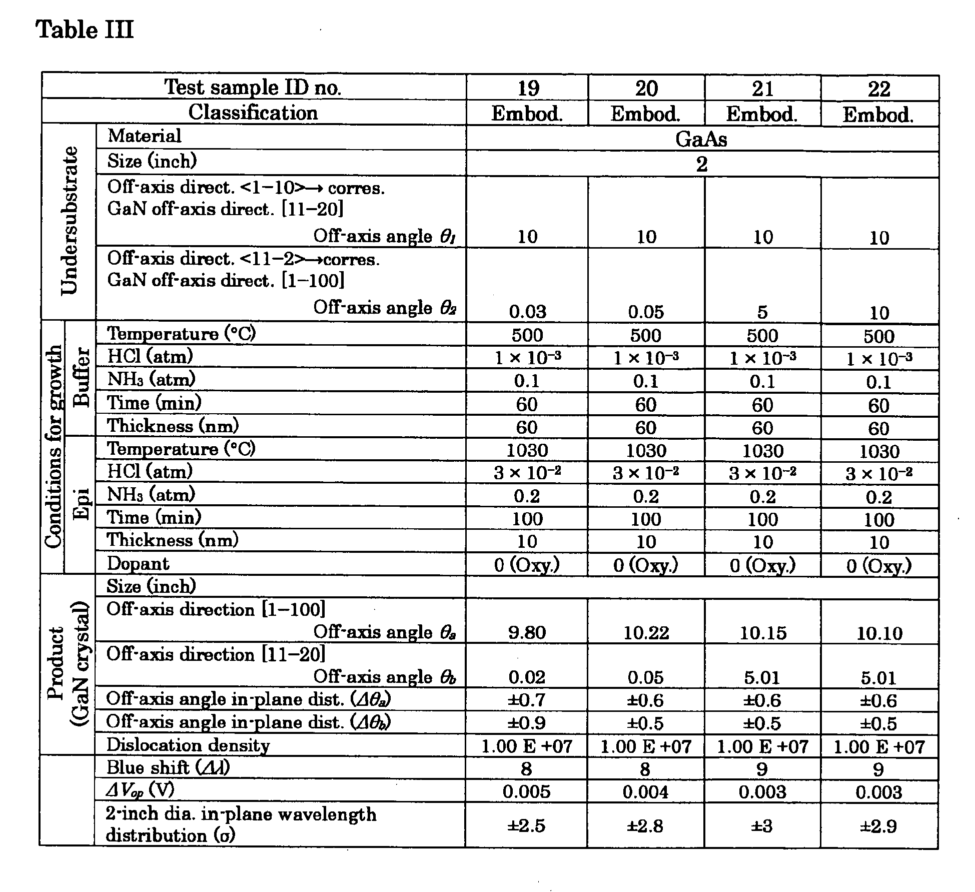

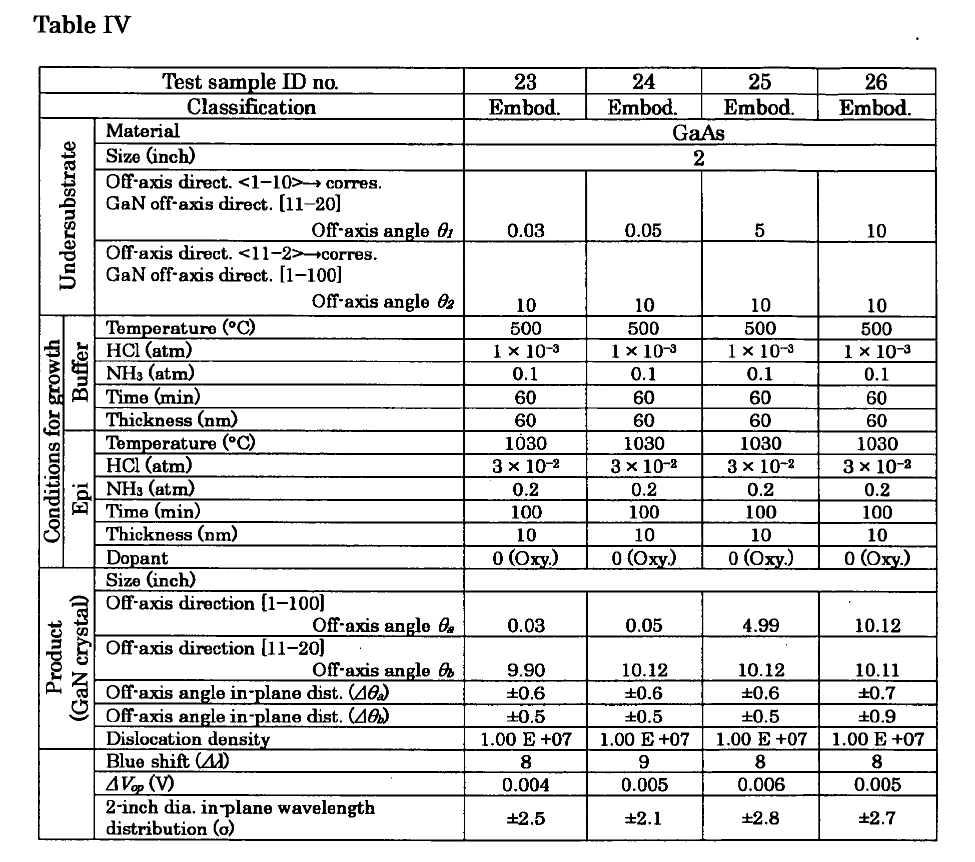

Tables III and IV demonstrate results from the measurement in which one of the undersubstrate off-axis angles θ1 and θ2 was fixed to 10°, and the other was fixed to 0.03° to 10° inclusive (that is, one of the GaN substrate off-axis angles θ*a* and θ*b* was fixed to around 10°, and the other was fixed to 0.02° or 0.03° to 10° inclusive). In the test samples demonstrated in Tables III and IV, in-plane distributions of the GaN substrate off-axis angles (Δθ*a* and Δθ*b)*, the amount of increase in operating voltage (ΔVₒₚ), and additionally, in-plane wavelength distribution (σ) are made smaller, compared with those in the test samples of the comparative and reference examples demonstrated in tables I and II. Although the reason is not clear, possible cause is that employing an undersubstrate (GaAs substrate) having off-axis angles in two directions to grow a GaN crystal layer keeps the undersubstrate compositions from being partially released from the undersubstrate (As, for example, if the undersubstrate is GaAs), with the result that the formed GaN crystal layer is prevented from warping. It is believed that consequently, off-axis angle in-plane distributions (Δθ*a* and Δ θ*b*) of the produced GaN substrates, and in-plane wavelength distribution (σ) are lessened.

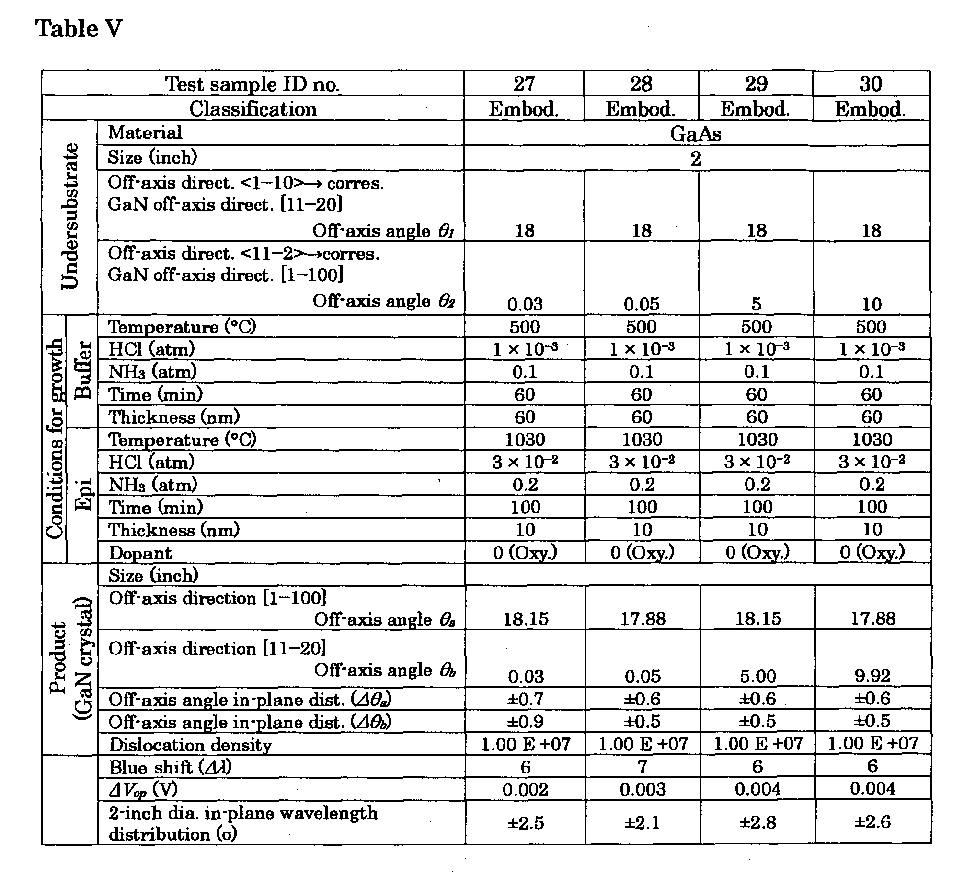

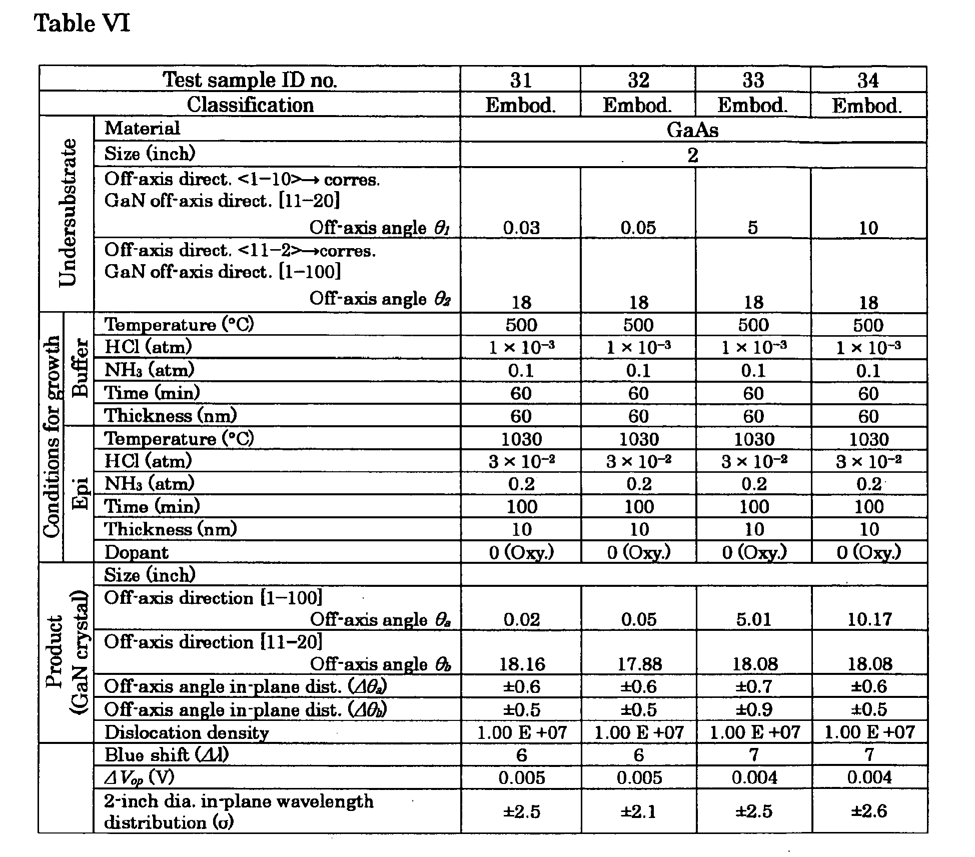

Tables V and VI demonstrate results from the measurement in which one of the undersubstrate off-axis angles θ1 and θ2 was fixed to 18°, and the other was fixed to between 0.02° or 0.03° and 10° inclusive (that is, one of the GaN substrate off-axis angles θ*a* and θ*b* was fixed to around 18°, and the other was fixed to between 0.02° or 0.03° and 10° inclusive).

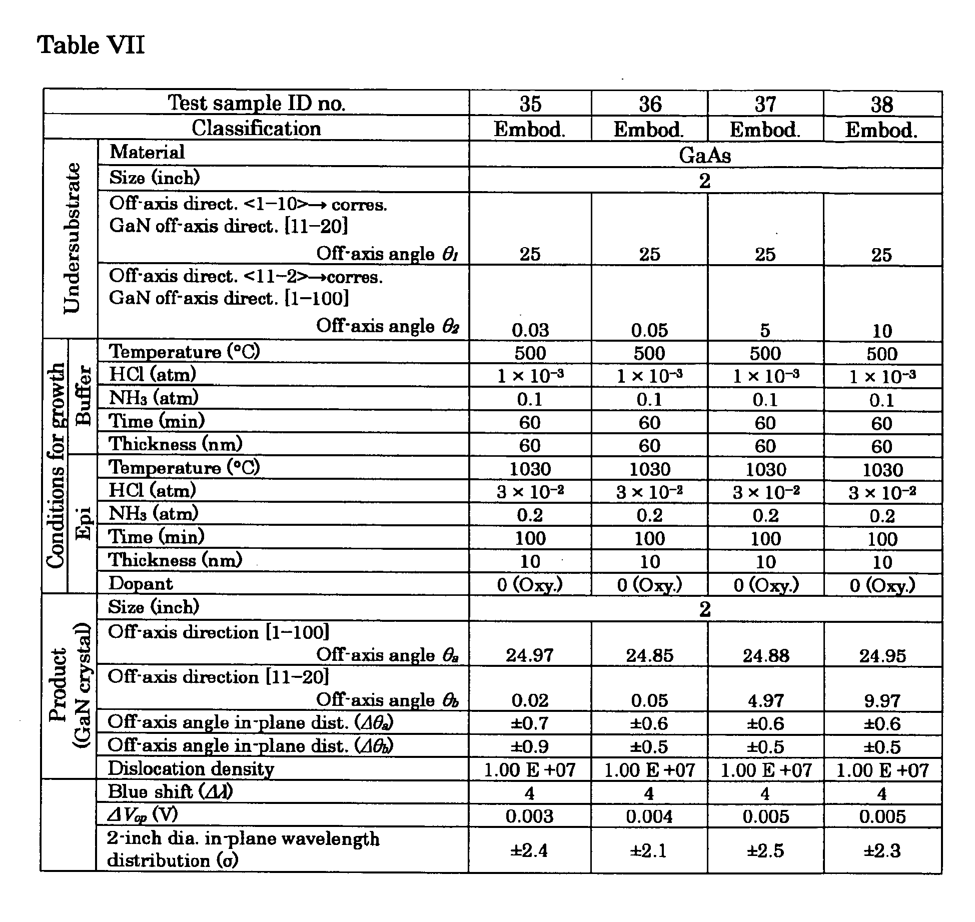

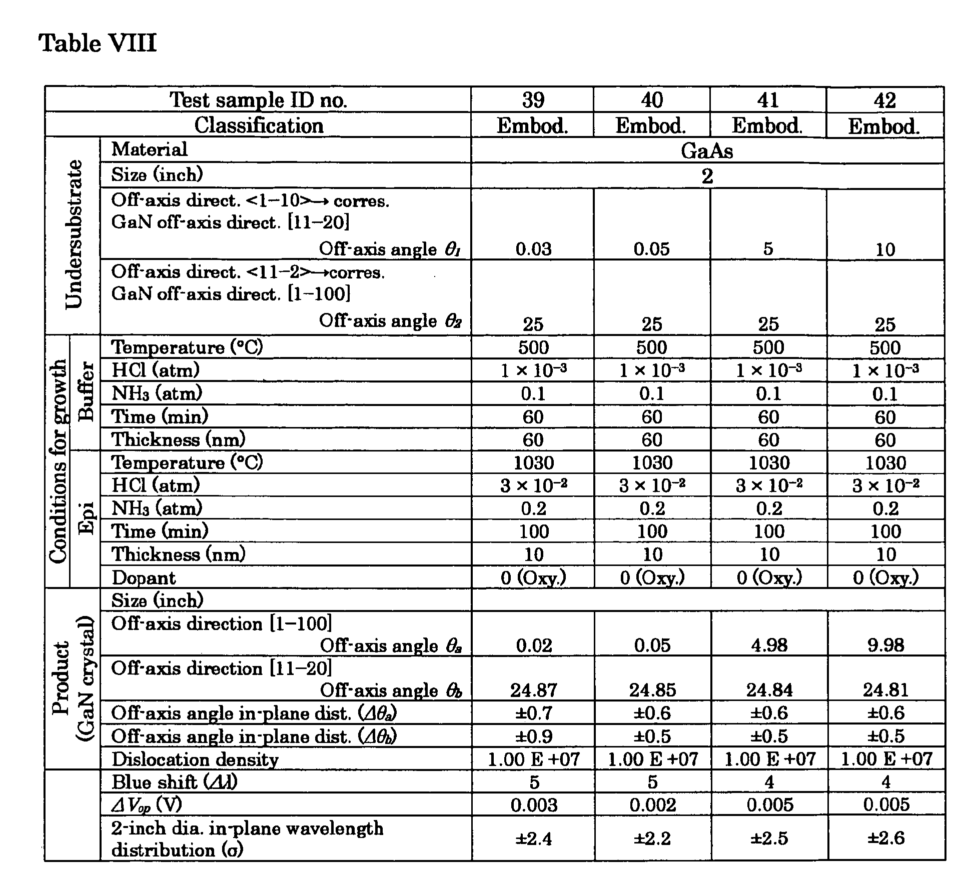

Tables VII and VIII demonstrate results from the measurement in which one of the undersubstrate off-axis angles θ1 and θ2 was fixed to 25°, and the other was fixed to between 0.03° and 10° inclusive (that is, one of the GaN substrate off-axis angles θ*a* and θ*b* was fixed to around 25°, and the other was fixed to between 0.02° and 10° inclusive).

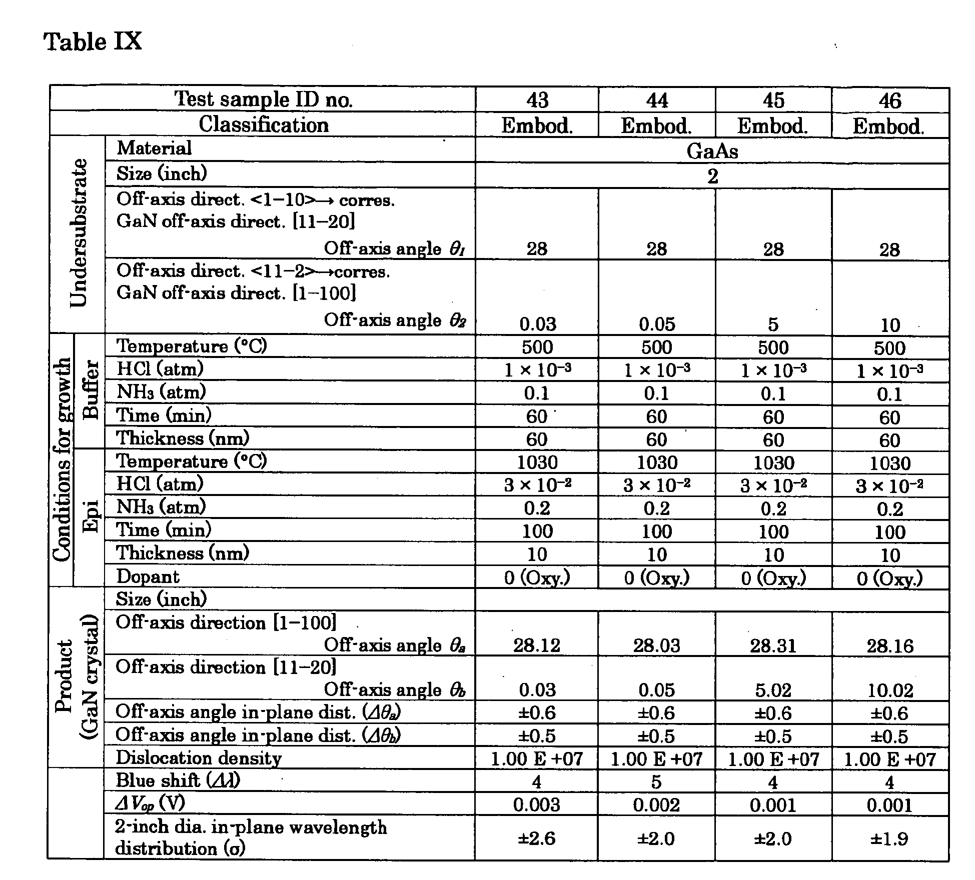

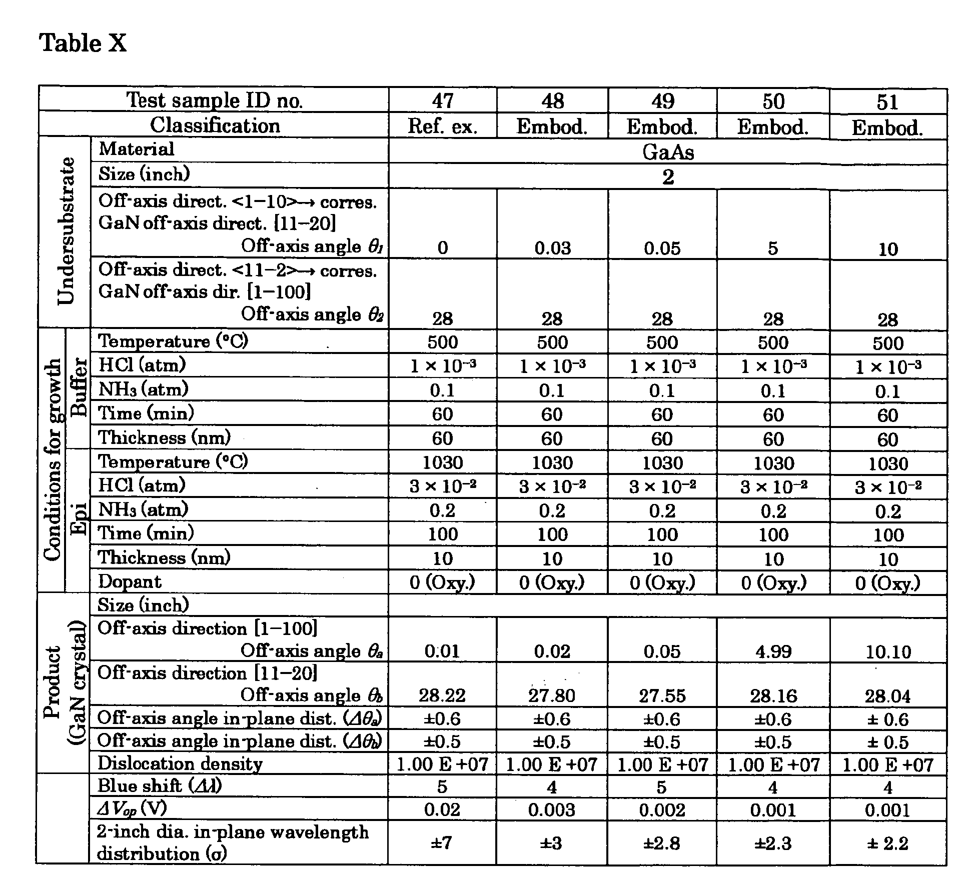

Tables IX and X demonstrate results from the measurement in which one of the undersubstrate off-axis angles θ1 and θ2 was fixed to 28°, and the other was fixed to between 0.03° and 10° inclusive (that is, one of the GaN substrate off-axis angles θ*a* and *θb* was fixed to around 28°, and the other was fixed to between 0.02° or 0.03° and 10° inclusive).

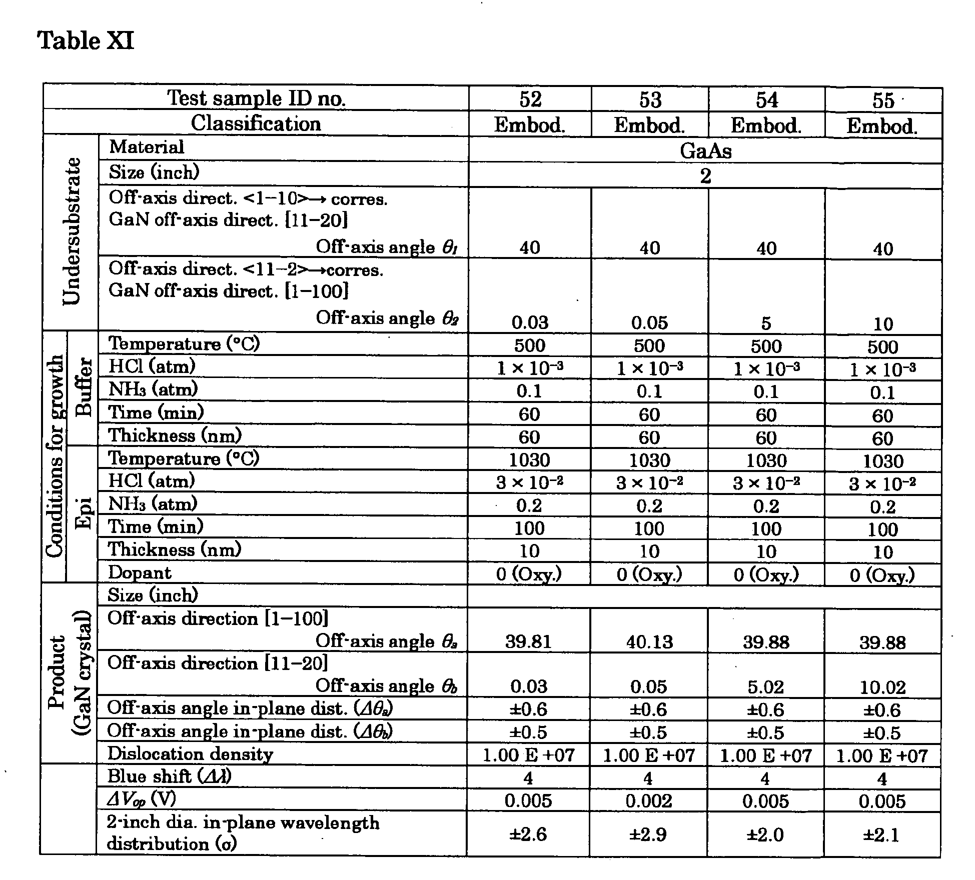

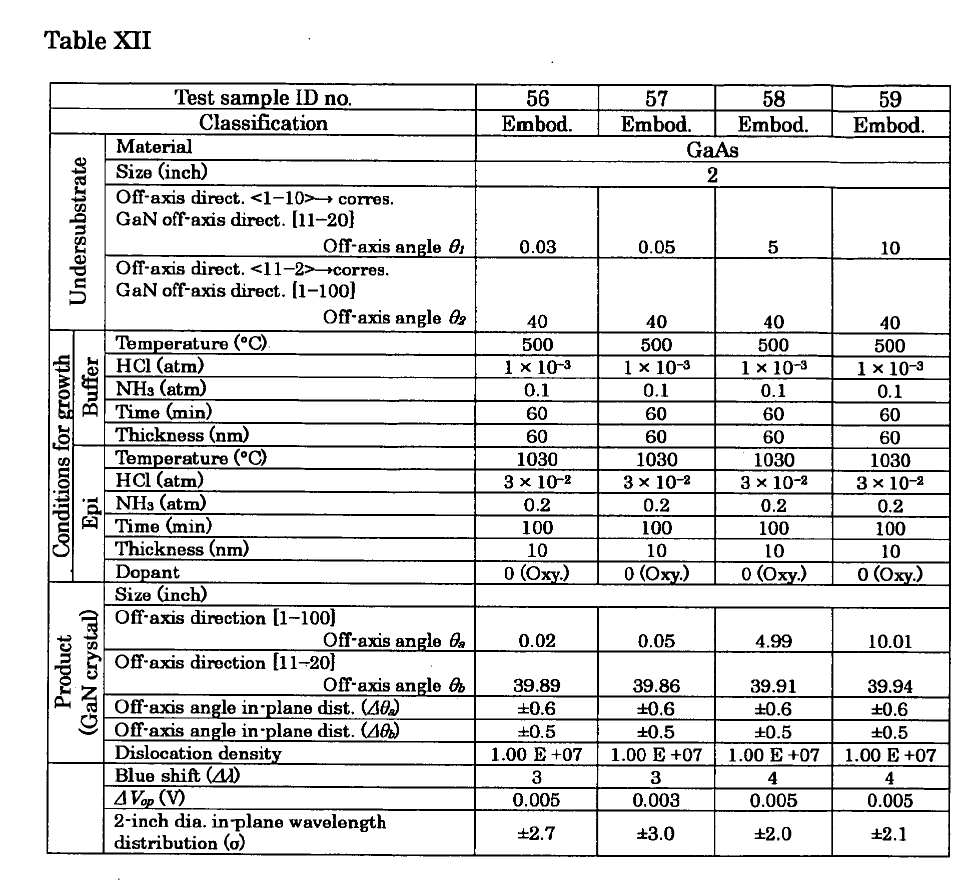

Tables XI and XII demonstrate results from the measurement in which one of the undersubstrate off-axis angles θ1 and θ2 was fixed to 40°, and the other was fixed to between 0.03° and 10° inclusive (that is, one of the GaN substrate off-axis angles θ*a* and θ*b* was fixed to around 40°, and the other was fixed to between 0.02° or 0.03° and 10° inclusive).

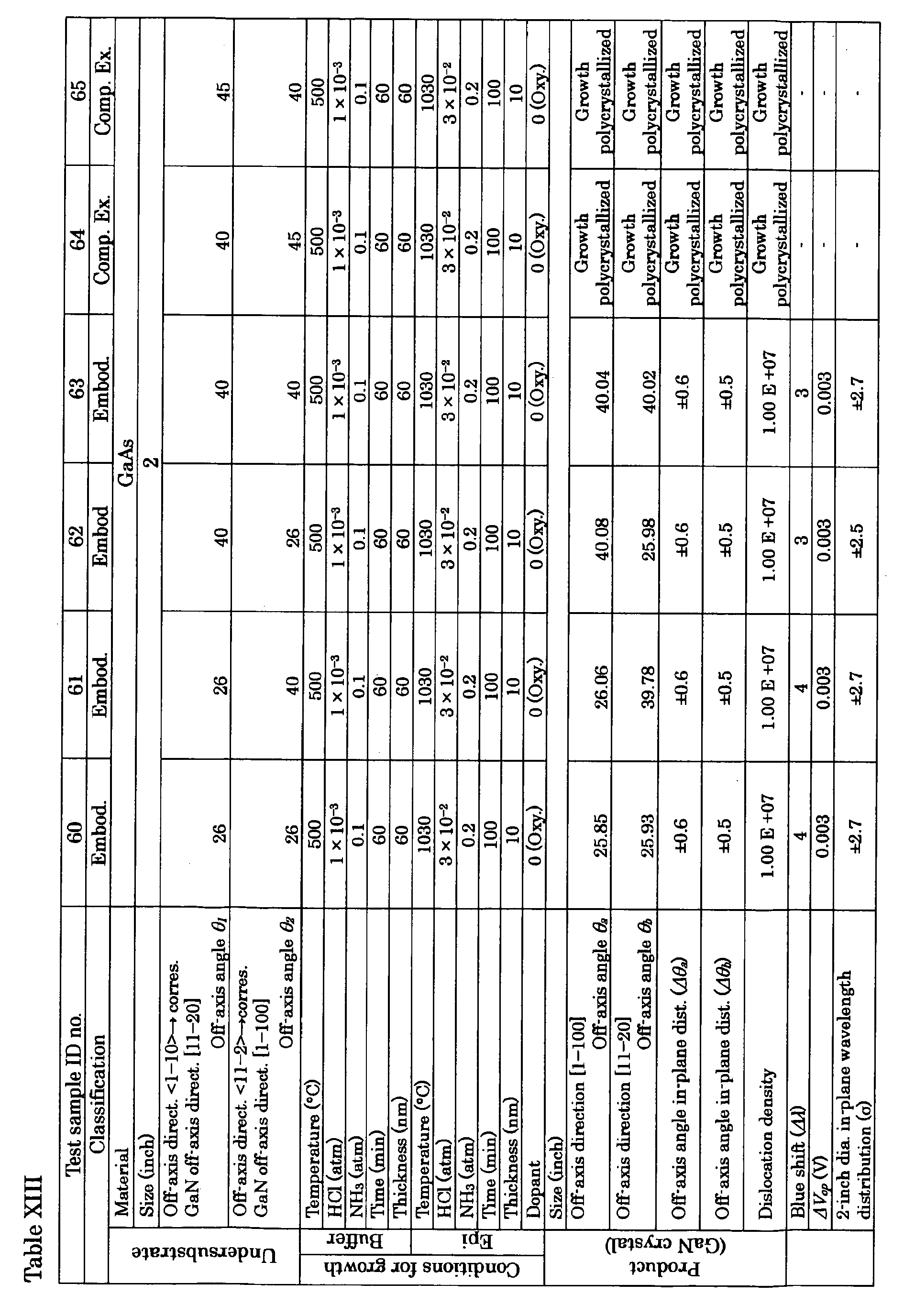

Table XIII shows the results from the measurement in which the undersubstrate off-axis angles θ1and θ2 were varied in the range from 26° to 45° inclusive (specifically, 26°, 40°, and 45°)-that is, the GaN substrate off-axis angles θ*a* and θ*b* were varied in the range from 26° to 45° inclusive. As is apparent from Table XIII, with any one of the undersubstrate off-axis angles θ1 and θ2 being made 40° or more (specifically, 45°), the GaN crystal layer could not be formed. On the other hand, in the GaN substrates, with the undersubstrate off-axis angles θ1 and θ2 being brought to 40° or less (that is, with the GaN substrate off-axis angles θ*a* and θ*b* being brought to 40° or less), in-plane distribution of the GaN substrate off-axis angles (Δθ*a* and Δ θ*b*), the amount of increase in operating voltage ,and in-plane wavelength distribution (σ) are all made smaller, compared with those in the the comparative and reference examples demonstrated in Tables I and II.

In the test samples of the embodiment, demonstrated in Tables III to XIII (specifically, in the test samples in which one of the GaN substrate off-axis angles θ*a* and θ*b* was brought to between 10° and 40° inclusive, and the other was brought to between 0.02° and 40° inclusive), in-plane distributions of GaN substrate off-axis angles (Δθ*a* and Δ θ*b*), the amount of increase in operating voltage (ΔVₒₚ), and in-plane wavelength distribution (σ) are made smaller, compared with those in the test samples of the comparative and reference examples demonstrated in Tables I and II.

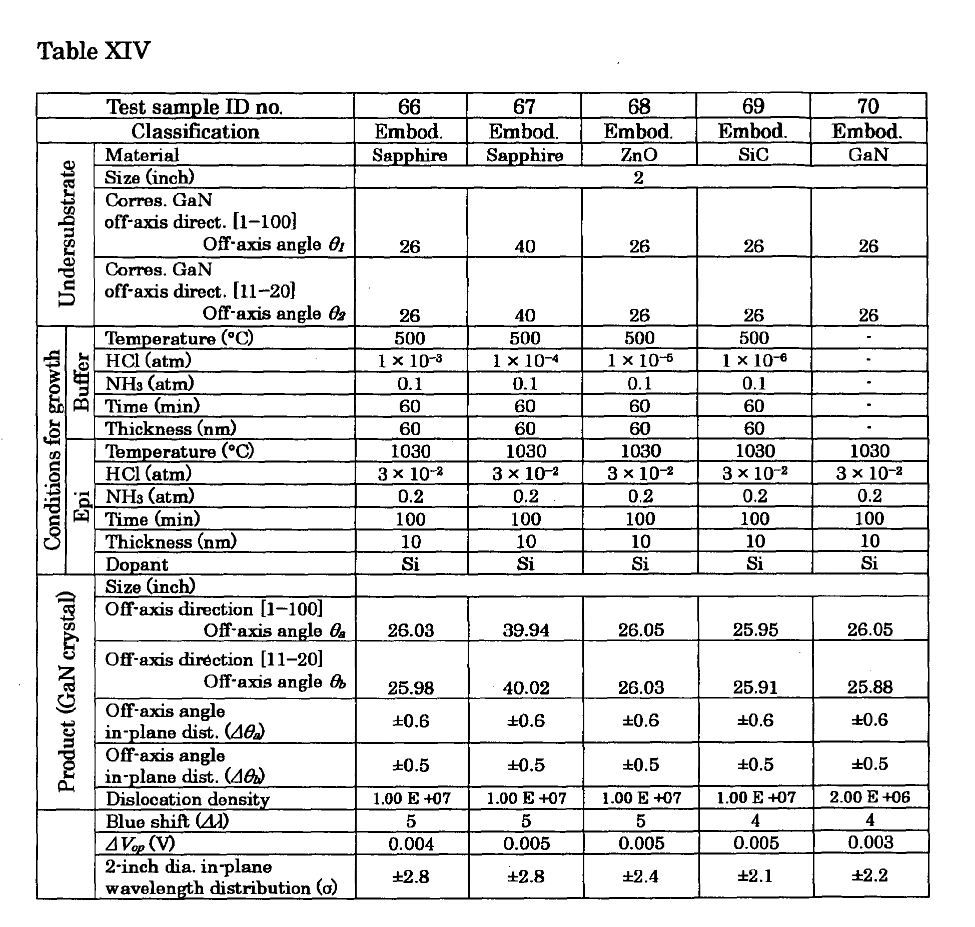

Table XIV demonstrates conditions for GaN film deposition, and measurement results, as to the test samples in which as undersubstrate, substrates composed of material other than GaAs were employed. As is apparent from the results of measuring the test samples: ID Nos. 66 to 70, even if the substrates (sapphire, ZnO, SiC, and GaN substrates) other than GaAs substrate are utilized as undersubstrate, the GaN substrates in which the [0001] plane orientation is inclined in two off-axis directions can be produced, as when utilizing GaAs substrate as undersubstrate. The resultant GaN substrates and light-emitting devices produced from the resultant GaN substrates exhibit the same properties as GaN substrates produced by utilizing as undersubstrate GaAs substrates, and as light-emitting devices produced from the GaN substrates utilizing GaAs undersubstrates. Herein, GaN substrates, which are not demonstrated in the Table, produced by employing sapphire, ZnO, SiC, and GaN substrates having the same off-axis angles as those of GaAs, and light-emitting devices produced by employing such the GaN substrates exhibit the same properties as those demonstrated in Tables I to XIII.

The presently disclosed embodiments and implementation examples should in all respects be considered to be illustrative and not limiting. The scope of the present invention is set forth not by the foregoing description but by the scope of the patent claims, and is intended to include meanings equivalent to the scope of the patent claims and all modifications within the scope.

The present invention is advantageously applied to GaN substrates employed in light-emitting devices that emit light having a relatively long wavelength (in a range of long wavelength of 500 nm or more), to epi-substrates in which an epitaxial layer is formed on the GaN substrate surfaces, and furthermore to semiconductor devices in which the GaN substrates were exploited.

Only selected embodiments have been chosen to illustrate the present invention. To those skilled in the art, however, it will be apparent from the foregoing disclosure that various changes and modifications can be made herein without departing from the scope of the invention as defined in the appended claims. Furthermore, the foregoing description of the embodiments according to the present invention is provided for illustration only, and not for limiting the invention as defined by the appended claims and their equivalents.

## Claims

1. A GaN substrate having a principal surface, wherein:
with respect to a vector normal to the principal surface, the [0001] plane
orientation is inclined in two off-axis directions differing from each other.

2. A GaN substrate as set forth in claim 1, wherein the two off-axis directions in which the [0001] plane orientation is inclined with respect to the principal-surface normal vector are the [1-100] and [11-20] directions.

3. A GaN substrate as set forth in claim 2, wherein one of either of the angles at which with respect to the principal-surface normal vector the [0001] plane orientation is inclined in the [1-100] direction and is inclined in the [11-20] direction is from 10° to 40° inclusive, and the other is from 0.02° to 40° inclusive.

4. An epi-substrate, comprising:
a GaN substrate as set forth in any of claims 1 through 3; and
an epitaxially grown layer formed onto the principal surface of said GaN substrate.

5. A semiconductor device in which an epi-substrate as set forth in claim 4 is utilized.

6. A method of manufacturing a GaN substrate having a principal surface, comprising:
a step of preparing an undersubstrate in which, with respect to a vector normal to the principal surface, the orientation of a fiducial plane is inclined toward said undersubstrate in two inclination directions differing from each other;
a step of growing a GaN crystal layer on the principal surface of said undersubstrate; and
a step of removing the undersubstrate from the GaN crystal layer to obtain a GaN substrate composed of the GaN crystal layer; wherein
the [0001] plane orientation is inclined, with respect to the normal to the principal surface, in two off-axis directions differing from each other, and
the inclination angles at which, in the GaN substrate, the [0001] plane orientation is inclined in the off-axis directions are adjusted by varying the inclination angles at which, in the undersubstrate, the fiducial plane orientation is inclined toward the undersubstrate in the inclination directions.

7. A GaN substrate manufacturing method as set forth in claim 6, wherein:
the undersubstrate is a GaAs substrate;
the fiducial plane orientation is [111];
the two directions of inclination toward the undersubstrate are the <1-10> and <11-2> directions; and
the two off-axis directions in the GaN substrate are the [11-20] and [1-100] directions.

8. A GaN substrate manufacturing method as set forth in claim 6, wherein:
the undersubstrate is a sapphire substrate;
the fiducial plane orientation is [0001];
the two directions of inclination toward the undersubstrate are the [11-20] and [1-100] directions; and
the two off-axis directions in the GaN substrate are the [1-100] and [11-20] directions.

9. A GaN substrate manufacturing method as set forth in claim 6, wherein:
the undersubstrate is a ZnO substrate;
the fiducial plane orientation is [0001];
the two directions of inclination toward the undersubstrate are the [1-100] and [11-20] directions; and
the two off-axis angles in the GaN substrate are the [1-100] and [11-20] directions.

10. A GaN substrate manufacturing method as set forth in claim 6, wherein:
the undersubstrate is a SiC substrate;
the fiducial plane orientation is [0001];
the two directions of inclination toward the undersubstrate are the [1-100] and [ 11-20] directions; and
the two off-axis directions in the GaN substrate are the [1-100] and [11-20] directions.

11. A GaN substrate manufacturing method as set forth in claim 6, wherein;
the undersubstrate is a substrate composed of GaN;
the fiducial plane orientation is [0001];
the two directions of inclination toward the undersubstrate are the [1-100] and [11-20] directions; and
the two off-axis angles in the GaN substrate are the [1-100] and [11-20] directions.

12. A GaN substrate manufacturing method as set forth in any of claims 6 through 10, further comprising a step of, prior to said step of growing the GaN crystal layer, forming on the principal surface of the undersubstrate a mask layer having a plurality of windows.

13. A GaN substrate manufacturing method as set forth in any of claims 6 through 12, wherein in the undersubstrate one of the angles of inclination in the two directions of inclination toward the undersubstrate is from 10° to 40° inclusive, and the other is from 0.02° to 40° inclusive.
